(19) **Europäisches Patentamt / European Patent Office / Office européen des brevets**

(11) **EP 4 300 583 B1**

(12) **FASCICULE DE BREVET EUROPEEN**

(45) Date de publication et mention de la délivrance du brevet:
**11.12.2024 Bulletin 2024/50**

(21) Numéro de dépôt: **23180685.2**

(22) Date de dépôt: **21.06.2023**

(51) Classification Internationale des Brevets (IPC):
**H01L 27/15** $^{(2006.01)}$    **H01L 33/08** $^{(2010.01)}$
**H01L 33/18** $^{(2010.01)}$    **H01L 33/20** $^{(2010.01)}$

(52) Classification Coopérative des Brevets (CPC):
**H01L 33/18; H01L 27/156; H01L 33/08;**
**H01L 33/20;** H01L 2933/0083

(54) **DISPOSITIF OPTOÉLECTRONIQUE À NANOFILS ET ZONES DE TRANSITIONS**

NANODRAHTBASIERTE OPTOELEKTRONISCHE VORRICHTUNG MIT ÜBERGANGSZONEN

NANOWIRE BASED OPTOELECTRONIC DEVICE WITH TRANSITION ZONES

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.06.2022 FR 2206586**

(43) Date de publication de la demande:
**03.01.2024 Bulletin 2024/01**

(73) Titulaire: **Aledia**
**38130 Echirolles (FR)**

(72) Inventeurs:
• **DAANOUNE, Mehdi**
**38140 RENAGE (FR)**
• **DUPONT, Tiphaine**
**38000 GRENOBLE (FR)**

(74) Mandataire: **Hautier IP**
**20, rue de la Liberté**
**06000 Nice (FR)**

(56) Documents cités:
**WO-A1-2014/154880**    **WO-A1-2022/002896**
**WO-A1-2022/069431**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

## DOMAINE TECHNIQUE

La présente invention concerne notamment le domaine des technologies de la microélectronique et de l'optoélectronique. Elle trouve pour application particulièrement avantageuse, mais non limitative, les systèmes d'affichage à base de LED (de l'anglais « Light-Emitting Diode », se traduisant en français par diode électroluminescente).

## ÉTAT DE LA TECHNIQUE

Les documents WO 2014/154880 A1, WO 2022/069431 A1, et WO 2022/002896 A1 font partie de l'arrière-plan technologique afférent à la présente invention.

Un écran d'affichage comprend généralement une pluralité de pixels disposés sur un plan dit basal et émettant indépendamment les uns des autres. Chaque pixel de couleur comprend généralement au moins trois composants d'émission et/ou de conversion d'un flux lumineux, également appelés sous-pixels. Ces sous-pixels émettent chacun un flux lumineux sensiblement dans une seule couleur (typiquement le rouge, le vert et le bleu). La couleur d'un pixel perçue par un observateur vient de la superposition des différents flux lumineux émis par les sous-pixels.

Typiquement, une LED ou micro-LED permet d'émettre le flux lumineux associé à un sous-pixel. Une LED peut notamment comprendre une pluralité de nanofils actifs arrangés en un cristal photonique périodique et émettant ledit flux lumineux à la longueur d'onde désirée. Ce cristal photonique se caractérise notamment par le diamètre des nanofils et le pas entre les nanofils.

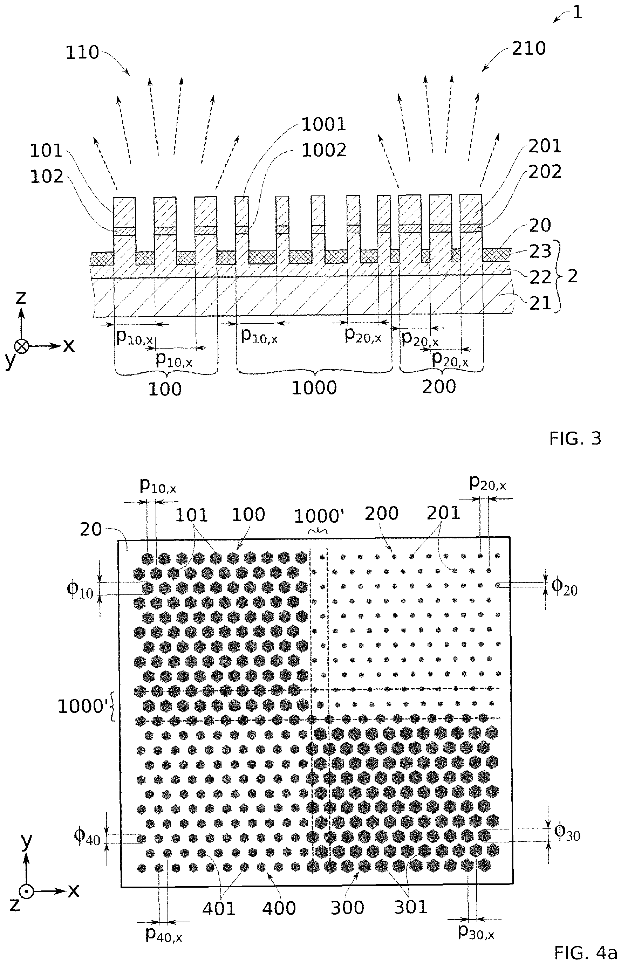

La figure 4a illustre un arrangement classique de sous-pixels au sein d'un pixel. En pratique cependant, ce type d'arrangement ne présente pas des performances optimales. Il existe donc un besoin pour améliorer les performances des pixels autoémissifs à base de nanofils.

## RÉSUMÉ

Pour atteindre cet objectif, selon la présente invention, on prévoit un dispositif optoélectronique selon la revendication indépendante 1 en annexe, comprenant au moins :

- une première LED s'étendant principalement dans un plan défini par une première direction et une deuxième direction, ladite première LED comprenant une pluralité de premiers nanofils présentant des premiers diamètres ayant une valeur sensiblement égale à une première valeur cible $\varphi_{10}$ et organisés en $N_{LED,x,1}$ rangées orientées selon la deuxième direction, dites premières rangées, lesdites premières rangées étant séparées par des premières distances prises selon la première direction ayant une valeur sensiblement égale à une première distance cible $P_{10,x}$, ladite première LED étant configurée pour émettre un premier faisceau lumineux présentant principalement une première longueur d'onde $\lambda_1$, et

- une première zone de transition s'étendant principalement dans le plan et bordant au moins en partie ladite première LED, ladite première zone de transition comprenant une pluralité de premiers nanofils de transition présentant des premiers diamètres de transition et organisés en $N_{trans,x,1}$ rangées orientées selon la deuxième direction, dites premières rangées de transition et indexées selon une numérotation de 1 à $N_{trans,x,1}$ en s'éloignant de la première LED selon la première direction, les premières rangées étant indexées selon une numérotation de 1 à $N_{LED,x,1}$ selon la première direction en se rapprochant de la première zone de transition,

le dispositif étant caractérisé en ce que la première zone de transition comprend une première sous-zone de transition formée par les $N_{sous\text{-}trans,1}$ premières rangées de transition, avec $2 \leq N_{sous\text{-}trans,1} \leq N_{trans,x,1}$, bordant la première LED, première sous-zone de transition dans laquelle :

- les premiers nanofils de transition sont tels que :

    i. la valeur des premiers diamètres de transition des premiers nanofils de transition de la première rangée de transition n°1 varie dans une proportion inférieure à 5% de la première valeur cible $\varphi_{10}$, et

    ii. la valeur du premier diamètre de transition de chaque premier nanofil de transition de toute première rangée de transition n°i, i étant compris entre 2 et $N_{sous\text{-}trans,1}$, varie dans une proportion comprise entre 3% et 13% de la valeur du premier diamètre de transition du premier nanofil de transition de la première rangée de transition n°i-1 lui étant le plus proche,

et/ou

- les premiers nanofils de transition sont tels que :

    i. la première rangée n°$N_{LED,x,1}$ et la première rangée de transition n°1 étant séparées selon la première direction x d'une première distance d'interface $d_{interface,1}$, la première distance d'interface $d_{interface,1}$ et la distance selon la première direction entre la première rangée de transition n°1 et la première rangée de transition n°2 varient dans une proportion comprise entre 2% et 4% de la distance selon la première direction entre la première rangée n°$N_{LED,x,1}$-1 et la première rangée n°$N_{LED,x,1}$ et la première distance d'interface $d_{interface,1}$ respectivement, et

ii. la distance selon la première direction entre toute première rangée de transition n°i et la première rangée de transition n°i+1 varie dans une proportion comprise entre 2% et 4% de la distance selon la première direction entre la première rangée de transition n°i-1 et la première rangée de transition n°i, i étant compris entre 2 et $N_{sous-trans,1}$-1.

Des modes de réalisation avantageux du dispositif optoélectronique selon la présente invention sont l'objet des revendications dépendantes en annexe.

Le dispositif optoélectronique peut également être décrit comme comprenant au moins :

- une première LED comprenant une pluralité de premiers nanofils présentant des premiers diamètres ayant une valeur sensiblement égale à une première valeur de diamètre cible $\varphi_{10}$ et organisés en rangées orientées selon une deuxième direction, dites premières rangées, et séparées par des premières distances prises selon une première direction ayant une valeur sensiblement égale à une première valeur de distance cible $p_{10,x}$, ladite première LED étant configurée pour émettre un premier faisceau lumineux présentant principalement une première longueur d'onde $\lambda1$, et

- une première zone de transition bordant au moins en partie ladite première LED, et comprenant une pluralité de premiers nanofils de transition présentant des premiers diamètres de transition et organisés en rangées orientées selon la deuxième direction, dites premières rangées de transition, et séparées par des premières distances de transition selon la première direction,

ladite première LED et ladite première zone de transition étant séparées, entre une première rangée et une première rangée de transition adjacentes, par une première distance d'interface selon la première direction, le dispositif étant caractérisé en ce que, en s'éloignant de la première LED selon la première direction :

- la valeur des premiers diamètres de transition de la première rangée de transition adjacente à la première LED varie dans une proportion inférieure à 5% de la première valeur de diamètre cible, et la valeur des premiers diamètres de transition varie de proche en proche, entre deux premières rangées de transition adjacentes, dans une proportion comprise entre 3% et 13%,

et/ou

- la valeur de la première distance d'interface est comprise entre 2% et 4% de la première valeur de distance cible, la valeur de la distance entre la première rangée de transition adjacente à la première LED et la première rangée de transition qui lui est adjacente est comprise entre 2% et 4% de la première distance d'interface, et la valeur des premières distances de transition varie de proche en proche, entre deux premières rangées de transition adjacentes, dans une proportion comprise entre 2% et 4%.

Un enjeu important de ces technologies concerne en effet les zones de transition entre sous-pixels adjacents. En effet, les sous-pixels constituant les écrans d'affichage actuels sont typiquement accolés les uns aux autres alors qu'un sous-pixel présente très souvent un diamètre de nanofils et un pas entre nanofils différents du sous-pixel voisin. Seules des zones de transition abrupte 1000' séparent les sous-pixels, comme représenté à la figure 4a. Il en va de même au niveau supérieur, entre pixels. La présence de ces zones de transition abrupte 1000' présente l'inconvénient de rompre la symétrie du réseau et, par conséquent, de créer des effets de bord préjudiciables lors de la croissance des nanofils. Ces effets de bord empêchent également de parvenir au niveau de chaque sous-pixel à un effet de cavité optique pourtant avantageux.

La présence d'une zone de transition permet d'éviter toute rupture de symétrie et de réduire le phénomène d'effets de bord.

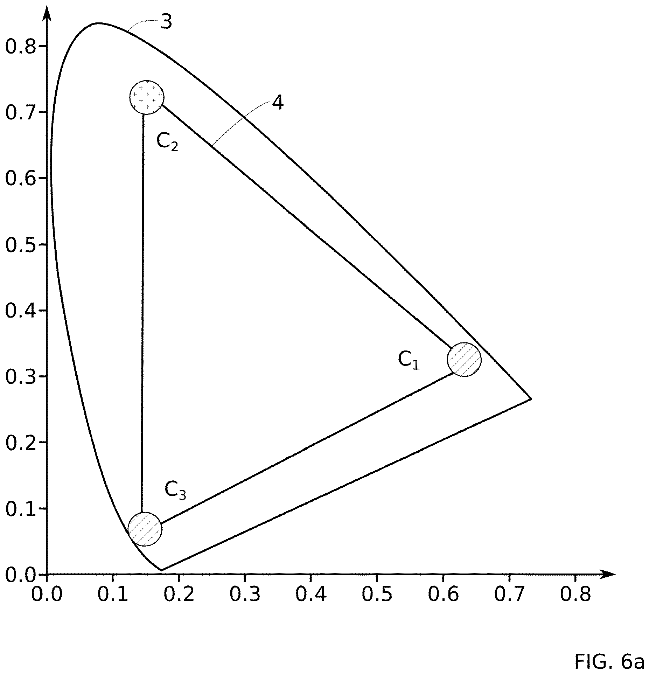

Selon une possibilité avantageuse, les nanofils de transition permettent également d'étendre le gamut d'un ensemble de sous-pixels, c'est-à-dire l'ensemble des couleurs qu'il permet de rendre. Le spectre des couleurs pouvant être émises par un pixel est en effet typiquement limité à l'ensemble des couleurs comprises dans le triangle défini par les couleurs natives émises par trois sous-pixels constituant ledit pixel sur le diagramme de chromaticité du système colorimétrique CIE (Commission Internationale de l'Eclairage) XYZ, typiquement le rouge ($C_1$), le vert ($C_2$) et le bleu ($C_3$), comme représenté à la figure 6a. Les couleurs comprises dans ce triangle, appelé gamut 4, sont en réalité obtenues par combinaisons linéaires des trois couleurs natives émises par les trois sous-pixels du pixel. Seule une gamme réduite de chromaticités peut ainsi être obtenue. La présente invention propose une solution pour étendre cette gamme.

Ainsi, dans cette optique, on prévoit que les premiers nanofils de transition présentent une région active configurée pour émettre un premier faisceau lumineux de transition présentant principalement une première longueur d'onde de transition distincte de la première longueur d'onde $\lambda1$.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente une vue de dessus du dispositif selon un mode de réalisation de l'invention, comprenant une LED et une zone de transition.

La figure 2 représente une vue de dessus du dispositif selon un mode de réalisation de l'invention, comprenant deux LEDs séparées par une zone de transition.

La figure 3 représente une coupe transverse du dispositif selon un mode de réalisation de l'invention, comprenant deux LEDs séparées par une zone de transition.

La figure 4a représente un dispositif à quatre LEDs présentant des zones de transition abruptes entre les LEDs, selon l'art antérieur.

La figure 4b représente un dispositif à quatre LEDs selon un mode de réalisation de l'invention, ce dispositif présentant des zones de transition progressives entre les LEDs.

La figure 5 représente un dispositif selon l'invention à trois LEDs séparées par des zones de transition progressives.

La figure 6a représente le diagramme de chromaticité d'un pixel couramment utilisé dans les écrans d'affichage actuels.

La figure 6b représente le diagramme de chromaticité d'un pixel pouvant être obtenu grâce au dispositif objet de l'invention.

La figure 7 représente un dispositif à trois LEDs selon un mode de réalisation de l'invention, ce dispositif présentant des zones de transition progressives actives entre les LEDs ainsi qu'une région intermédiaire émettant de la lumière blanche.

La figure 8 représente un dispositif selon l'invention à deux LEDs séparées par une zone de transition progressive.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions de chacun des éléments ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation, les premiers diamètres de transition des premiers nanofils de transition d'une même première rangée de transition sont égaux.

Selon un mode de réalisation :

- la valeur des premiers diamètres de transition des premiers nanofils de transition des premières rangées de transition présente une évolution strictement croissante ou strictement décroissante sur au moins trois premières rangées de transition successives en s'éloignant de la première LED, et/ou
- la distance entre deux premières rangées de transition successives en s'éloignant de la première LED présente une évolution strictement croissante ou strictement décroissante sur au moins trois premières rangées de transition successives en s'éloignant de la première LED.

Selon un mode de réalisation :

- la valeur des premiers diamètres de transition des premiers nanofils de transition des premières rangées de transition présente une évolution linéaire sur au moins trois premières rangées de transition successives en s'éloignant de la première LED, et/ou
- la distance entre deux premières rangées de transition successives en s'éloignant de la première LED présente une évolution linéaire sur au moins trois premières rangées de transition successives en s'éloignant de la première LED.

Selon un mode de réalisation les premiers nanofils et les premiers nanofils de transition sont en outre organisés en rangées selon la première direction.
Selon un mode de réalisation la première direction et la deuxième direction sont orthogonales.
Selon un mode de réalisation la première sous-zone de transition s'étend sur au moins trois rangées, de préférence au moins cinq rangées, de premiers nanofils de transition.
Selon un mode de réalisation la première sous-zone de transition présente une surface $S_{1000}$ et la première LED présente une surface $S_{100}$ telles que $S_{100}/5 < S_{1000} < S_{100}/2$.
Selon un mode de réalisation les premiers nanofils d'une part et les premiers nanofils de transition d'autre part sont alimentés par des contacts électriques distincts.
Selon un mode de réalisation le dispositif comprend en outre :

- une deuxième LED s'étendant principalement dans le plan, ladite deuxième LED comprenant une pluralité de deuxièmes nanofils présentant des deuxièmes diamètres ayant une valeur sensiblement égale à un deuxième diamètre cible $\varphi_{20}$ et organisés en $N_{LED,x,2}$ rangées orientées selon la deuxième direction, dites deuxièmes rangées, et indexées selon une numérotation de 1 à $N_{LED,x,2}$ en s'éloignant de la première zone de transition selon la première direction, lesdites deuxièmes rangées étant séparées par des premières distances prises selon la première direction ayant une valeur sensiblement égale à une deuxième distance cible $p_{20,x}$, ladite deuxième LED étant configurée pour émettre un deuxième faisceau lumineux présentant principalement une deuxième

longueur d'onde $\lambda_2$,

lesdites première et deuxième LEDs étant séparées au moins par la première zone de transition.

Selon un mode de réalisation $N_{sous\text{-}trans,1} = N_{trans,x,1}$ et :

- la valeur des premiers diamètres de transition des premiers nanofils de transition de la première rangée de transition n°$N_{sous\text{-}trans,1}$ varie dans une proportion inférieure à 5% du deuxième diamètre cible $\varphi_{20}$, et/ou
- la deuxième rangée n°1 et la première rangée de transition n°$N_{sous\text{-}trans,1}$ étant séparées selon la première direction d'une deuxième distance d'interface $d_{interface,2}$,
- la distance selon la première direction entre la première rangée de transition n°$N_{sous\text{-}trans,1}$ et la première rangée de transition n°$N_{sous\text{-}trans,1}$-1 varient dans une proportion comprise entre 2% et 4% de la deuxième distance d'interface $d_{interface,2}$.

Selon un mode de réalisation la première zone de transition comprend une deuxième sous-zone de transition formée par les premières rangées de transition n°$N_{sous\text{-}trans,2}$ à $N_{trans,x,1}$, avec $N_{sous\text{-}trans,1} \leq N_{sous\text{-}trans,2} < N_{trans,x,1}$, deuxième sous-zone de transition dans laquelle :

- les premiers nanofils de transition sont tels que :

     i. la valeur des premiers diamètres de transition des premiers nanofils de transition de la première rangée de transition n° $N_{trans,x,1}$ varie dans une proportion inférieure à 5% du deuxième diamètre cible $\varphi_{20}$, et
     ii. la valeur des premiers diamètres de transition des premier nanofil de transition de toute première rangée de transition n°i, i étant compris entre $N_{sous\text{-}trans,2}$ et $N_{trans,x,1}$-1 varie dans une proportion comprise entre 3% et 13% de la valeur des premiers diamètres de transition des premiers nanofils de transition de la première rangée de transition n°i+1,

     et/ou
- les premiers nanofils de transition sont tels que :

     i. la deuxième rangée n°1 et la première rangée de transition n° $N_{trans,x,1}$ étant séparées selon la première direction x d'une deuxième distance d'interface $d_{interface,2}$, la distance selon la première direction (x) entre la première rangée de transition n°$N_{trans,x,1}$ et la première rangée de transition n°$N_{trans,x,1}$-1 et la deuxième distance d'interface $d_{interface,2}$ varient dans une proportion comprise entre 2% et 4% de la deuxième distance d'interface $d_{interface,2}$ et de la distance selon la première direction (x) entre la deuxième rangée n°1 et la deuxième rangée n°2 respectivement,
     ii. la distance selon la première direction entre toute première rangée de transition n°i et la première rangée de transition n°i-1 varie dans une proportion comprise entre 2% et 4% de la distance selon la première direction entre la première rangée de transition n°i et la première rangée de transition n°i+1, i étant compris entre $N_{trans,x,1}$-1 et $N_{sous\text{-}trans,2}$+1.

Selon un mode de réalisation :

- la valeur des premiers diamètres de transition des premiers nanofils de transition des premières rangées de transition présente une évolution strictement croissante ou strictement décroissante sur au moins trois premières rangées de transition successives en s'éloignant de la deuxième LED, et/ou
- la distance entre deux premières rangées de transition successives en s'éloignant de la première LED présente une évolution strictement croissante ou strictement décroissante sur au moins trois premières rangées de transition successives en s'éloignant de la deuxième LED.

Selon un mode de réalisation :

- la valeur des premiers diamètres de transition des premiers nanofils de transition des premières rangées de transition présente une évolution linéaire sur au moins trois premières rangées de transition successives en s'éloignant de la deuxième LED, et/ou
- la distance entre deux premières rangées de transition successives en s'éloignant de la première LED présente une évolution linéaire sur au moins trois premières rangées de transition successives en s'éloignant de la deuxième LED.

Selon un mode de réalisation les deuxièmes rangées sont espacées selon la première direction x d'une distance dite deuxième pas $p_2$.

Selon un mode de réalisation $N_{sous\text{-}trans,1} < N_{sous\text{-}trans,2}$ et dans lequel :

- la distance entre les premières rangées de transition n°$N_{sous\text{-}trans,1}$ à n°$N_{seuil,1}$, avec $N_{sous\text{-}trans,1} < N_{seuil,1} \leq N_{sous\text{-}trans,2}$ est constante et/ou,
- les premiers diamètres de transition des premiers nanofils de transition des premières rangées de transition n°$N_{sous\text{-}trans,1}$ à n°$N_{seuil,1}$, avec $N_{sous\text{-}trans,1} < N_{seuil,1} \leq N_{sous\text{-}trans,2}$ sont constants,

formant ainsi une sous-zone dite première sous-zone seuil.

Selon un mode de réalisation au moins une partie des premiers nanofils de transition comprennent une région active configurée pour émettre un premier faisceau lumineux de transition.

Selon un mode de réalisation le premier faisceau lumineux de transition présente principalement une première longueur d'onde de transition $\lambda_{trans,1}$, avec $\lambda_{trans,1} \neq \lambda_1$ et $\lambda_{trans,1} \neq \lambda_2$.

Selon un mode de réalisation :

- les premiers nanofils sont organisés en $N_{LED,y,1}$ rangées orientées selon la première direction, dites premières rangées secondaires, indexées selon une numérotation de 1 à $N_{LED,y,1}$ et séparées par des premières distances secondaires prises selon la deuxième direction ayant une valeur sensiblement égale à une première distance secondaire cible $p_{10,y}$, et
- les deuxièmes nanofils sont organisés en $N_{LED,y,2}$ rangées orientées selon la première direction, dites deuxièmes rangées secondaires et indexées selon une numérotation de 1 à $N_{LED,y,2}$ et séparées par des deuxièmes distances secondaires prises selon la deuxième direction ayant une valeur sensiblement égale à une deuxième distance secondaire cible $p_{20,y}$.

Selon un mode de réalisation le dispositif comprend en outre :

- une troisième LED s'étendant principalement dans le plan, ladite troisième LED comprenant une pluralité de troisièmes nanofils présentant des troisièmes diamètres ayant une valeur sensiblement égale à un troisième diamètre cible $\varphi_{30}$ et organisés en $N_{LED,x,3}$ rangées orientées selon la deuxième direction, dites troisièmes rangées et en $N_{LED,y,3}$ rangées orientées selon la première direction, dites troisièmes rangées secondaires, ladite troisième LED étant configurée pour émettre un troisième faisceau lumineux présentant principalement une troisième longueur d'onde $\lambda_3$,
- une deuxième zone de transition s'étendant principalement dans le plan et bordant au moins en partie ladite deuxième LED et ladite troisième LED, ladite deuxième zone de transition comprenant une pluralité de deuxièmes nanofils de transition présentant des deuxièmes diamètres de transition et organisés en $N_{trans,y,2}$ rangées orientées selon la première direction, dites deuxièmes rangées de transition secondaires et indexées selon une numérotation de 1 à $N_{trans,y,2}$ en se rapprochant de la deuxième LED selon la deuxième direction,
- une troisième zone de transition s'étendant principalement dans le plan et bordant au moins en partie ladite troisième LED et ladite première LED, ladite troisième zone de transition comprenant une pluralité de troisièmes nanofils de transition présentant des troisièmes diamètres de transition et organisés en $N_{trans,y,3}$ rangées orientées selon la première direction, dites troisièmes rangées de transition secondaires et indexées selon une numérotation de 1 à $N_{trans,y,3}$ en se rapprochant de la première LED selon la deuxième direction,

lesdites deuxième et troisième LEDs étant séparées par la deuxième zone de transition, lesdites troisième et première LEDs étant séparées par la troisième zone de transition, dans lequel les deuxièmes nanofils de la deuxième zone de transition sont tels que :

    i. la valeur des deuxièmes diamètres de transition des deuxièmes nanofils de transition de la deuxième rangée de transition n°1 varie dans une proportion inférieure à 5% du troisième diamètre cible $\varphi_{30}$, et

    ii. la valeur du deuxième diamètre de transition de chaque deuxième nanofil de transition de toute deuxième rangée de transition secondaire n°i, i étant compris entre 2 et $N_{trans,y,2}$, varie dans une proportion comprise entre 3% et 13% de la valeur du deuxième diamètre de transition du deuxième nanofil de transition de la deuxième rangée de transition secondaire n°i-1 lui étant le plus proche, et

    iii. la valeur des deuxièmes diamètres de transition des deuxièmes nanofils de transition de la deuxième rangée de transition n°$N_{trans,y,2}$ varie dans une proportion inférieure à 5% du deuxième diamètre cible $\varphi_{20}$, et/ou

    i. la deuxième rangée secondaire n°1 et la deuxième rangée de transition secondaire n°$N_{trans,y,2}$ étant séparées selon la deuxième direction (y) d'une troisième distance d'interface $d_{interface,3}$, la troisième distance d'interface $d_{interface,3}$ et la distance selon la deuxième direction (y) entre la deuxième rangée de transition secondaire n°$N_{trans,y,2}$ et la deuxième rangée de transition secondaire n° $N_{trans,y,2}$-1 varient dans une proportion comprise entre 2% et 4% de la distance selon la deuxième direction (y) entre la deuxième rangée de transition secondaire n°$N_{trans,y,2}$ et la deuxième rangée de transition secondaire n°$N_{trans,y,2}$-1 et la troisième distance d'interface $d_{interface,3}$ respectivement,

    ii. la distance selon la deuxième direction entre toute deuxième rangée de transition secondaire n°i et la deuxième rangée de transition secondaire n°i+1 varie dans une proportion comprise entre 2% et 4% de la distance selon la deuxième direction entre la deuxième rangée de transition secondaire n°i-1 et la deuxième rangée de transition secondaire n°i, i étant compris entre 2 et $N_{trans,y,2}$-1 ,et

iii. la troisième rangée secondaire n° $N_{LED,y,3}$ et la deuxième rangée de transition secondaire n°1 étant séparées selon la deuxième direction d'une quatrième distance d'interface $d_{interface,4}$, la quatrième distance d'interface $d_{interface,4}$ et la distance selon la deuxième direction entre la deuxième rangée de transition secondaire n°2 et la deuxième rangée de transition secondaire n°1 varient dans une proportion comprise entre 2% et 4% de la distance selon la deuxième direction entre la troisième rangée secondaire n°$N_{LED,y,3}$ et la troisième rangée secondaire n° $N_{LED,y,3}$-1 et la quatrième distance d'interface $d_{interface,4}$ respectivement,

et dans lequel les troisièmes nanofils de la troisième zone de transition sont tels que :

i. la valeur des troisièmes diamètres de transition des troisièmes nanofils de transition de la troisième rangée de transition n°1 varie dans une proportion inférieure à 5% du troisième diamètre cible $\varphi_{30}$, et

ii. la valeur du troisième diamètre de transition de chaque troisième nanofil de transition de toute troisième rangée de transition secondaire n°i, i étant compris entre 2 et $N_{trans,y,3}$, varie dans une proportion comprise entre 3% et 13 de la valeur du troisième diamètre de transition du troisième nanofil de transition de la troisième rangée de transition secondaire n°i-1 lui étant le plus proche, et

iii. la valeur des troisièmes diamètres de transition des troisièmes nanofils de transition de la troisième rangée de transition n°$N_{trans,y,3}$ varie dans une proportion inférieure à 5% du premier diamètre cible $\varphi_{10}$, et/ou

i. la première rangée secondaire n°1 et la troisième rangée de transition secondaire n° $N_{trans,y,3}$ étant séparées selon la deuxième direction d'une sixième distance d'interface $d_{interface,6}$, la sixième distance d'interface $d_{interface,6}$ et la distance selon la deuxième direction entre la troisième rangée de transition secondaire n°$N_{trans,y,3}$ et la troisième rangée de transition secondaire n° $N_{trans,y,3}$-1 varient dans une proportion comprise entre 2% et 4% de la distance selon la deuxième direction entre la troisième rangée de transition secondaire n°$N_{trans,y,3}$ et la troisième rangée de transition secondaire n° $N_{trans,y,3}$-1 et la sixième distance d'interface $d_{interface,3}$ respectivement,

ii. la distance selon la deuxième direction entre toute troisième rangée de transition secondaire n°i et la troisième rangée de transition secondaire n°i+1 varie dans une proportion comprise entre 2% et 4% de la distance selon la deuxième direction entre la troisième rangée de transition secondaire n°i-1 et la troisième rangée de transition secondaire n°i, i étant compris entre 2 et $N_{trans,y,3}$-1 ,et

iii. la troisième rangée secondaire n° $N_{LED,y,3}$ et la troisième rangée de transition secondaire n°1 étant séparées selon la deuxième direction d'une cinquième distance d'interface $d_{interface,5}$, et la cinquième distance d'interface $d_{interface,5}$ et la distance selon la deuxième direction entre la troisième rangée de transition secondaire n°2 et la troisième rangée de transition secondaire n°1 varient dans une proportion comprise entre 2% et 4% de la distance selon la deuxième direction entre la troisième rangée secondaire n°$N_{LED,y,3}$ et la troisième rangée secondaire n° $N_{LED,y,3}$-1 et la quatrième distance d'interface $d_{interface,4}$ respectivement.

Selon un mode de réalisation le dispositif comprend en outre une région intermédiaire bordée par la première zone de transition, la deuxième zone de transition, la troisième zone de transition et la troisième LED, ladite région intermédiaire comprenant une pluralité de nanofils intermédiaires présentant une distribution de diamètres de sorte que l'ensemble desdits nanofils intermédiaires émette à une pluralité de longueurs d'onde distribuées sur l'ensemble du spectre visible.

On entend par fil ou par nanofil une structure 3D de forme allongée selon la direction longitudinale. La dimension longitudinale de la structure 3D, selon z sur les figures, est supérieure, et de préférence très supérieure, aux dimensions transverses de la structure 3D, dans le plan xy sur les figures. La dimension longitudinale est par exemple au moins cinq fois, et de préférence au moins dix fois, supérieure aux dimensions transverses.

On entend par diamètre la dimension transverse la plus grande du nanofil. Dans la présente invention, les structures 3D ne présentent pas nécessairement une section transverse circulaire. En particulier, dans le cas de structures 3D à base de GaN, cette section peut être hexagonale. Le diamètre correspond alors à la distance séparant deux sommets opposés de la section hexagonale. Alternativement, le diamètre peut correspondre à un diamètre moyen calculé à partir du diamètre d'un cercle inscrit dans le polygone de la section transverse et du diamètre d'un cercle circonscrit de ce polygone.

Les structures 3D peuvent également présenter une section transverse hexagonale ou polygonale.

Dans la présente demande de brevet, les termes « diode électroluminescente », « LED » ou simplement « diode » sont employés en synonymes. Une « LED » peut également s'entendre d'une « micro-LED ».

Dans la suite, les abréviations suivantes relatives à un matériau M sont éventuellement utilisées :

M-i réfère au matériau M intrinsèque ou non intentionnellement dopé, selon la terminologie habituellement utilisée dans le domaine de la microélectronique pour le suffixe -i.

M-n réfère au matériau M dopé N, N+ ou N++, selon la terminologie habituellement utilisée dans le domaine de la microélectronique pour le suffixe -n.

M-p réfère au matériau M dopé P, P+ ou P++, selon la terminologie habituellement utilisée dans le domaine de la microélectronique pour le suffixe -p.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une structure 3D à base de nitrure de gallium (GaN) peut par exemple comprendre du nitrure de gallium (GaN ou GaN-i) ou du nitrure de gallium dopé (GaN-p, GaN-n). Une région active à base de nitrure de gallium-indium (InGaN) peut par exemple comprendre du nitrure de gallium-aluminium (AlGaN) ou du nitrure de gallium avec différentes teneurs en aluminium et en indium (GaInAlN). Dans le cadre de la présente invention, le matériau M est généralement cristallin.

Un repère, de préférence orthonormé, comprenant les axes x, y, z est représenté sur les figures annexées.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de $90 \pm 10°$ par rapport au plan.

On entend par « faisceau lumineux présentant principalement une longueur d'onde $\lambda$ » un faisceau dont la longueur d'onde pic du spectre se situe à la longueur d'onde $\lambda$. Le spectre du faisceau suit typiquement une répartition gaussienne. Le pic du spectre s'entend alors comme la valeur maximale de la gaussienne.

On entend par « faisceau lumineux émis principalement selon une direction d » un faisceau dont l'intensité lumineuse maximale se situe dans l'axe définissant la direction d.

Pour déterminer la géométrie des structures 3D et les compositions des différents éléments (fil, région active, collerette par exemple) de ces structures 3D, on peut procéder à des analyses de Microscopie Electronique à Balayage (MEB) ou de Microscopie Electronique en Transmission (MET ou TEM pour l'acronyme anglais de « Transmission Electron Microscopy ») ou encore ou de Microscopie Electronique en Transmission à Balayage STEM (acronyme anglais de « Scanning Transmission Electron Microscopy »).

Le TEM ou le STEM se prêtent notamment bien à l'observation et à l'identification des puits quantiques - dont l'épaisseur est généralement de l'ordre de quelques nanomètres - dans la région active. Différentes techniques listées ci-après de façon non exhaustive peuvent être mises en oeuvre : l'imagerie en champ sombre (dark field) et en champ clair (bright field), en faisceau faible (weak beam), en diffraction aux grands angles HAADF (acronyme anglais de « High Angle Annular Dark Field »).

Les compositions chimiques des différents éléments peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de dispositifs optoélectroniques de petites tailles tels que des LED 3D. Elle peut être mise en oeuvre sur des coupes métallurgiques au sein d'un Microscope Electronique à Balayage (MEB) ou sur des lames minces au sein d'un Microscope Electronique en Transmission (MET).

Les propriétés optiques des différents éléments, et notamment les longueurs d'onde principales d'émission des LED 3D axiales à base de GaN et/ou des régions actives à base d'InGaN, peuvent être déterminées par spectroscopie.

Les spectroscopies de cathodoluminescence (CL) et de photoluminescence (PL) sont bien adaptées pour caractériser optiquement les structures 3D décrites dans la présente invention.

Les techniques mentionnées ci-dessus permettent notamment de déterminer si un dispositif optoélectronique à structure 3D axiale sous forme de fil comprend des puits quantiques à base d'InGaN formés au sommet d'un fil à base de GaN, et une couche de masquage indicatrice d'une mise en oeuvre d'un dépôt de type MOVPE.

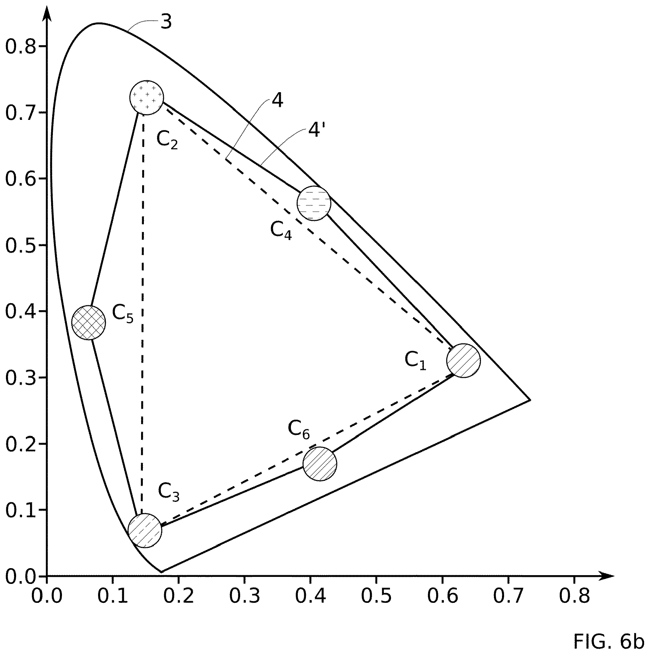

Il est à noter que dans les diagrammes de chromaticité représentés aux figures 6a et 6b, les coordonnées correspondent aux coordonnées trichromatiques x et y typiquement définies par les normes du système colorimétrique CIE XYZ.

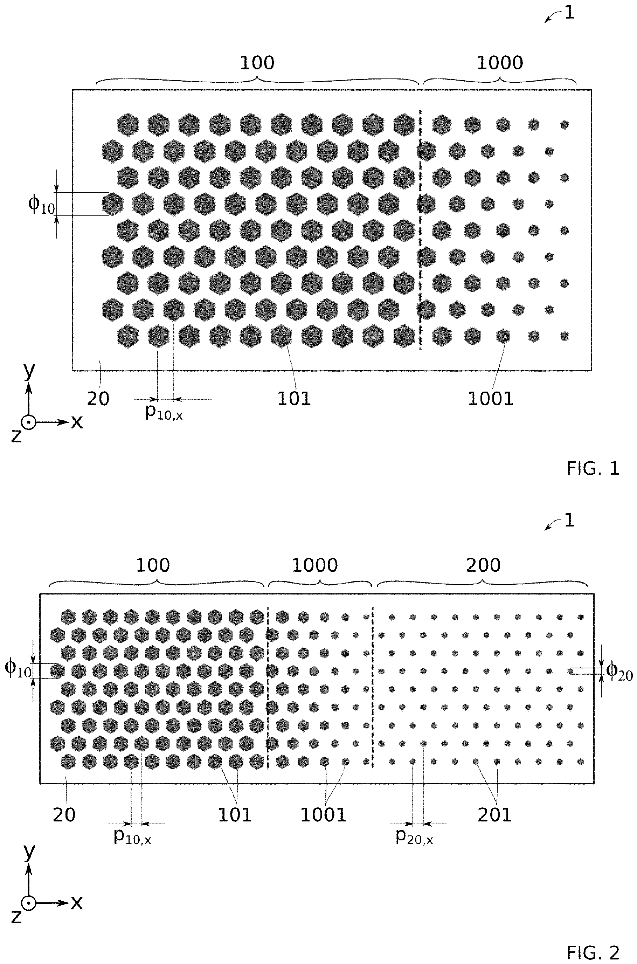

Comme illustré à la figure 3, le dispositif optoélectronique 1 objet de l'invention comprend typiquement un substrat 2 s'étendant selon le plan xy représenté sur les figures 1 à 5. Le substrat présente une face supérieure 20 s'étendant elle aussi selon la première direction et la deuxième direction. Le substrat 2 peut se présenter sous forme d'un empilement comprenant, selon la direction z, un support 21, une couche superficielle dite couche de nucléation 22 et une couche de masquage 23.

Le support 21 peut être notamment en saphir pour limiter le désaccord de paramètre de maille avec le GaN, ou en silicium pour réduire les coûts et pour des problématiques de compatibilité technologique. Dans ce dernier cas, il peut se présenter sous forme d'un wafer de diamètre 200 mm ou 300 mm. Il sert notamment de support aux structures 3D.

La couche de nucléation 22 est par exemple à base d'AlN. Elle peut être alternativement à base d'autres nitrures métalliques, par exemple GaN ou AlGaN. Elle peut être formée sur le support 21 en silicium par épitaxie, de préférence par épitaxie en phase vapeur à précurseurs organométalliques MOVPE (acronyme de « MetalOrganic Vapour Phase Epitaxy »). De façon connue, une ou plusieurs couches tampon intermédiaires peuvent être disposées entre la couche de nucléation 22 et le support 21. Selon un exemple la couche de nucléation 22 présente une épaisseur comprise entre 1 nm et 10 $\mu$m. Elle présente de préférence une épaisseur de l'ordre de quelques centaines de nanomètres, par exemple environ 100 nm ou 200 nm, à quelques microns, par exemple de l'ordre de 2 $\mu$m. Elle peut également présenter une épaisseur inférieure à 100 nm. Une telle épaisseur permet de limiter l'apparition de défauts structuraux dans la couche de nucléation 22. En particulier, la croissance de cette couche de nucléation 22 peut être pseudomorphe, c'est-à-dire que les contraintes d'épitaxie (liées notamment à la différence de paramètres de maille entre le Si et l'AlN, le GaN ou l'AlGaN) peuvent être relâchées élastiquement pendant la croissance. La qualité cristalline de cette couche de nucléation 22 peut ainsi être optimisée.

La couche de masquage 23 est de préférence en un matériau diélectrique, par exemple en nitrure de silicium Si3N4. Elle peut être déposée par dépôt chimique en phase vapeur CVD (acronyme de « Chemical Vapor Déposition ») sur la couche de nucléation 22. Elle masque en partie la couche de nucléation 22 et comprend des ouvertures de préférence circulaires exposant des zones de la couche de nucléation 22. Ces ouvertures présentent typiquement différentes dimensions, par exemple différents diamètres, en fonction des zones considérées, notamment les zones correspondant à la première LED et/ou à la première zone de transition et/ou à la deuxième LED et/ou à la deuxième zone de transition etc. Les ouvertures peuvent être distribuées de façon régulière au sein de chaque zone, par exemple sous forme d'un réseau ordonné. Différents pas d, i.e. la distance séparant les centres de deux ouvertures 120 adjacentes, peuvent être définis en fonction desdites zones. Ces ouvertures peuvent être réalisées par exemple par lithographie UV ou DUV (acronyme de Deep UV), par lithographie par faisceau électronique ou par NIL (acronyme de Nanoinprint lithography). Une telle couche de masquage 23 permet une croissance localisée d'une structure 3D telle qu'un nanofil à partir de la couche de nucléation 22 et au niveau de chaque ouverture. La partie inférieure de la structure 3D prend alors appui sur la couche de nucléation du substrat 2 par l'intermédiaire de sa base.

Le dispositif optoélectronique 1 comprend de plus une première LED 100 disposée sur la face supérieure 20 du substrat 2 et s'étendant elle aussi dans le plan xy. Cette première LED 100 comprend typiquement au moins un nanofil actif 101. Un tel nanofil 101 s'étend avantageusement à partir de l'éventuelle couche de nucléation 22 et à travers une ouverture de l'éventuelle couche de masquage 23 du substrat 2. La première LED 100 comprend avantageusement une pluralité de premiers nanofils 101 actifs, comme représenté sur l'ensemble des figures 1 à 5.

Les premiers nanofils 101 présentent des premiers diamètres ayant une valeur sensiblement égale à une valeur cible dite premier diamètre cible $\varphi_{10}$. Il est entendu que, du fait des imprécisions découlant des procédés de fabrication, les premiers nanofils 101 peuvent difficilement tous présenter un diamètre égal au premier diamètre cible $\varphi_{10}$. On définit donc pour chaque premier nanofil un premier diamètre réel noté $\varphi_{1,n}$, n indexant les premiers nanofils et variant donc de 1 à $N_1$, $N_1$ étant le nombre de premiers nanofils 101. Ce premier diamètre réel est de préférence tel que $0,9.\varphi_{10} < \varphi_{1,n} < 1,1.\varphi_{10}$. Les variations de la valeur du diamètre de nanofils dues aux aléas de fabrication peuvent en effet être estimées à environ 10% de la valeur cible.

Un premier nanofil actif 101 comprend une région active 102 et est typiquement connecté électriquement. Cette région active 102 est le lieu de recombinaisons radiatives de paires électron-trou permettant d'obtenir un rayonnement lumineux présentant une longueur d'onde principale. La région active 102 comprend typiquement une pluralité de puits quantiques, par exemple formés par des couches émissives à base de GaN, InN, InGaN, AlGaN, AlN, AlInGaN, GaP, AlGaP, AlInGap, AlGaAs, GaAs, InGaAs, AlIAs, ou d'une combinaison de plusieurs de ces matériaux.

L'ensemble des premiers nanofils 101 actifs de la première LED 100 forme de préférence un cristal photonique pouvant être décrit par plusieurs paramètres et notamment :

- la longueur d'onde d'émission,
- le pas de réseau,
- le taux de remplissage, aussi appelé taux d'ouverture ou densité, généralement compris entre 10 et 90%,
- le type de maille (hexagonal, carré...),
- l'indice de réfraction du matériau remplissant les espaces entre les nanofils 101, couramment appelé « filler » (terme anglais se traduisant par « remplisseur »), préférentiellement compris entre 1 et 1,7, et
- les dimensions des nanofils.

Un cristal est typiquement caractérisé par le rapport entre le pas de réseau, couramment désigné par le terme anglais « pitch », et la longueur d'onde d'émission.

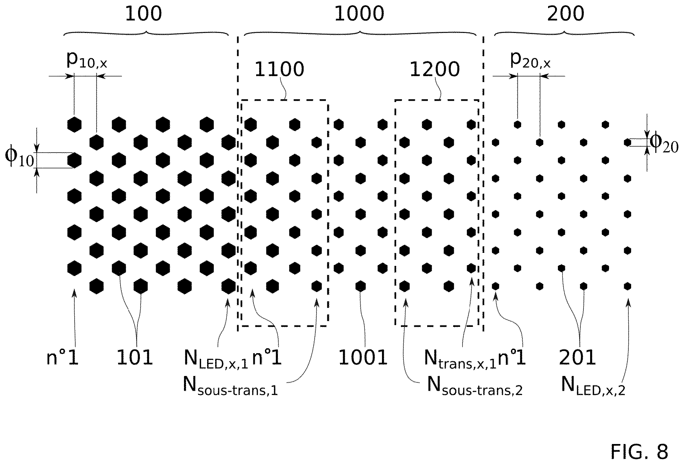

Comme illustré sur la figure 8, les premiers nanofils 101 sont avantageusement disposés selon des rangées orientées selon une première direction et/ou une deuxième direction. Ces rangées sont nommées premières rangées et premières rangées secondaires respectivement. Sur les figures, la première direction et la deuxième direction correspondent respectivement aux directions x et y du repère orthonormé. Ainsi, sur les figures, la première direction et la deuxième direction sont normales. Il est cependant envisageable qu'elles ne le soient pas. Les premières rangées et les premières rangées secondaires sont respectivement au nombre de $N_{LED,x,1}$ et $N_{LED,y,1}$. Elles sont par ailleurs repérées à l'aide d'une indexation allant de 1 à $N_{LED,x,1}$ et de 1 à $N_{LED,y,1}$ respectivement.

L'ensemble de ces rangées et donc des premiers nanofils 101 forme avantageusement un réseau à deux dimensions régulier. Il peut par exemple s'agir d'un réseau monoclinique, d'un réseau orthorhombique, d'un réseau tétragonal ou encore d'un réseau hexagonal.

Les premières rangées sont avantageusement séparées par des premières distances prises selon la première direction ayant une valeur sensiblement égale à une première distance cible $p_{10,x}$. Il est entendu que du fait des imprécisions découlant des procédés de fabrication, la distance entre deux premières rangées voisines peut varier autour de la première distance cible $p_{10,x}$. Les variations de la valeur de la distance entre deux premières rangées voisines dues aux aléas de fabrication peuvent être estimées à environ 10% de la valeur cible.

La première LED 100 comprend typiquement une couche à base d'un oxyde conducteur transparent, couramment dénommée TCO (de l'anglais « Transparent Conductive Oxide »), dont l'épaisseur est de préférence comprise entre 100 et 300 nm. Les nanofils peuvent être disposés, selon la direction longitudinale, entre une couche miroir à base d'un matériau métallique, typiquement de l'Al, et la couche TCO. Cette disposition des nanofils entre la couche miroir et la couche TCO permet éventuellement de créer une cavité Fabry-Perot dans la direction longitudinale.

La première LED 100 est avantageusement dimensionnée pour présenter des dimensions de l'ordre de celles d'un sous-pixel d'un dispositif d'affichage.

La première LED 100 est configurée pour émettre un premier faisceau lumineux 110. De manière avantageuse, le premier faisceau lumineux 110 est configuré pour être émis principalement selon une direction normale au substrat 2, soit s'étendant parallèlement à l'axe z représenté sur les figures 1 à 5, dite direction longitudinale. Le faisceau lumineux 110 comprend cependant une multitude de rayons se propageant selon autant de directions d'émission. L'émission est par exemple omnidirectionnelle. Selon un autre mode de réalisation, les rayons du faisceau sont typiquement émis selon un profil lambertien ou orthotrope, c'est-à-dire que la luminance de la LED 100 est uniforme angulairement, mais que l'intensité lumineuse émise dépend de la direction d'émission. L'intensité lumineuse du faisceau varie typiquement selon la loi de Lambert :

$$I = I_0 \cos(\theta)$$

avec I l'intensité lumineuse selon une direction d'émission, $I_0$ l'intensité lumineuse à la source et θ l'angle de la direction d'émission par rapport à la normale à la surface source, ici la direction longitudinale. Il est entendu que tout autre profil d'émission est envisageable et que la première LED 100 n'est pas limitée à une source lambertienne.

Le dispositif 1 comprend de plus une première zone de transition 1000 bordant au moins en partie la première LED 100.

La première zone de transition 1000 comporte une pluralité de premiers nanofils de transition 1001 s'étendant dans la direction transverse depuis la face supérieure 20 du substrat 2.

Les premiers nanofils de transition 1001 peuvent être actifs ou passifs suivant l'utilisation que l'on désire en faire. On entend par « nanofil passif » un nanofil n'émettant pas de rayonnement lumineux. Un nanofil passif est typiquement similaire à un nanofil actif mais n'est pas connecté électriquement.

Les premiers nanofils de transition 1001 forment de préférence un cristal photonique s'étendant sur le substrat 2. Les paramètres permettant de décrire ce cristal photonique sont les mêmes que ceux décrivant le cristal photonique formé par les nanofils actifs 102 (pas de réseau, type de maille, taux de remplissage...), à l'exception de la longueur d'émission qui ici n'est pas définie lorsque les premiers nanofils de transition sont passifs.

Les premiers nanofils de transition 1001 sont avantageusement disposés selon des rangées orientées selon la première direction x et/ou la deuxième direction y. Ces rangées sont nommées premières rangées de transition et premières rangées de transition secondaires et sont au nombre de $N_{trans,x,1}$ et $N_{trans,y,1}$ respectivement. Elles sont par ailleurs repérées à l'aide d'une indexation allant de 1 à $N_{LED,x,1}$ en s'éloignant de la première LED 100 et de 1 à $N_{LED,y,1}$ respectivement.

Avantageusement, l'ensemble des premiers nanofils de transition 1001 forme un réseau à deux dimensions régulier, de préférence du même type que l'ensemble des premiers nanofils 101. Cela permet d'optimiser la fabrication de la première LED 100 et de la première zone de transition 1000, qui se fait avantageusement simultanément.

On prévoit la présence d'une sous-zone de transition 1100 bordant la première LED 100 et formée par $N_{sous-trans,1}$ premières rangées de transition, $N_{sous-trans,1}$ étant compris entre 2 et $N_{trans,x,1}$. Les premiers nanofils de transition 1001 de la première sous-zone de transition 1100 ont la particularité de présenter des diamètres dits premiers diamètres de transition et/ou des distances entre premières rangées de transition consécutives évoluant en s'éloignant de la première LED 100. Cette particularité permet d'éviter un changement abrupt de diamètre et/ou de distance entre nanofils en bordure de la première LED. Cela permet d'éviter les effets de bord nuisant à l'efficacité de la première LED 100.

Les variations de la valeur des premiers diamètres de transition des premiers nanofils de transition 1001 ou de la valeur de la distance entre deux rangées consécutives de premiers nanofils de transition en s'éloignant de la première LED 100 est en effet fondamental.

Ces variations au sein de la première sous-zone de transition 1100 peuvent admettre différentes lois de progression de s'éloignant de la première LED 100. Les variations en diamètres et les variations relatives à la distance entre deux premières rangées de transition consécutives peuvent admettre des lois de progression similaires ou distinctes. Ces variations peuvent par exemple être monotones voire strictement monotones, c'est-à-dire croissantes ou décroissantes voire strictement croissantes ou strictement décroissantes. La variation de ces paramètres peut de plus être linéaire. Il n'est en outre pas exclu qu'un des deux paramètres présente une évolution croissante puis décroissante en s'éloignant de la première LED, ou inversement. Le diamètre et/ou la distance entre deux rangées consécutives peut en effet augmenter dans certaines régions de la première sous-zone de transition 1100 et diminuer dans d'autres régions de la première sous-zone de transition 1100, en fonction des applications visées. Avantageusement, on prévoit que les premiers nanofils de transition 1001 constituant les premières rangées de transition bordant immédiatement la première LED 100 présentent des premiers diamètres de transition variant de façon monotone sur plusieurs rangées, par exemple 3 à 5 rangées. De la même façon, on prévoit avantageusement que la distance entre deux premières rangées de transition consécutives varie de façon monotone sur plusieurs premières rangées de transition bordant immédiatement la première LED, par exemple 3 à 5 rangées. On entend par « premières rangées de transition bordant immédiatement la première LED » les premières rangées de transition que l'on rencontre en premier en s'éloignant de la première LED 100 selon la première direction x. En d'autres termes, ce sont les premiers nanofils de transition 1001 présentant la distance selon x à la LED 100 la plus faible, ou encore l'indexation la plus faible.

Quelle que soit la loi suivie par les variations des diamètres des premiers nanofils de transition et des distances entre premières rangées de transition au sein de la première sous-zone de transition 1100, pour éviter toute transition abrupte du premier diamètre de transition et/ou de la distance entre deux rangées consécutives en s'éloignant de la première LED 100, on prévoit que ces variations soient bornées. On prévoit notamment qu'en s'éloignant de la première LED 100, le diamètre des nanofils de transition 1001 de deux rangées consécutives ne puisse augmenter ou diminuer que de 3 à 13% de la rangée qui la précède. Le pas entre deux rangées consécutives en s'éloignant de la première LED 100, lui, ne peut augmenter ou diminuer que de 2 à 4% par rapport au pas qui le précède.

On prévoit également, afin d'éviter toute transition abrupte entre la première LED 100 et la première zone de transition 1000, que les premiers nanofils de transition 1001 bordant immédiatement la première LED 100 présentent un diamètre proche du diamètre cible des premiers nanofils 101 de la première LED 100. Leur diamètre varie typiquement dans une proportion inférieure à 5% de $\varphi_{10}$.

Dans la même optique, on prévient toute transition abrupte de la distance entre nanofils au niveau de l'interface entre la première LED 100 et la première zone de transition 1000. On définit pour ce faire une première distance d'interface $d_{interface,1}$ séparant la première rangée bordant la première zone de transition 1000 (première rangée n°$N_{LED,x,1}$) et la première rangée de transition bordant la première LED 100 (première rangée de transition n°1). La valeur de la première distance d'interface $d_{interface,1}$ et celle de la distance selon la première direction x entre la première rangée de transition n°1 et la première rangée de transition n°2 varient dans une proportion comprise entre 2% et 4% de la distance selon la première direction x entre la première rangée n°$N_{LED,1}$-1 et la première rangée n°$N_{LED,1}$ et la première distance d'interface $d_{interface,1}$ respectivement.

Il est également envisageable que la première zone de transition 1000 comprenne une sous-zone bordant la première sous-zone de transition, dite sous-zone seuil, dans laquelle l'un au moins des deux paramètres parmi le diamètre des premiers nanofils de transition 1001 et la distance entre les premières rangées de transition voisines reste constant en s'éloignant de la première LED 100.

L'alimentation électrique d'un ensemble de nanofils actifs est typiquement réalisée de façon parallèle. Les nanofils actifs d'un même ensemble sont en effet classiquement connectés en parallèle à une électrode supérieure et une électrode inférieure agencées sous le substrat 2 depuis lequel s'étendent lesdits nanofils actifs.

Dans le cadre de l'invention, on prévoit avantageusement que les premiers nanofils 101 de la première LED 100 et les premiers nanofils de transition 1001 de la première zone de transition 1000 soient alimentés séparément, par des électrodes distinctes. Une telle séparation permet notamment de contrôler quels nanofils sont alimentés et par conséquent quelles zones émettent. Cette caractéristique trouve tout son avantage dans l'application de la présente invention relative à l'extension du gamut du dispositif décrite plus loin. Il n'est cependant pas exclu que les premiers nanofils 101 de la première LED 100 et les premiers nanofils de transition 1001 de la première zone de transition 1000 soient alimentés simultanément par une même électrode.

Selon un mode de réalisation avantageux illustré à la figure 2, le dispositif optoélectronique 1 comprend une deuxième LED 200 disposée sur la face supérieure du substrat 2 et adjacente à la première LED 100. Les deux LED 100, 200, peuvent être assimilées à deux sous-pixels adjacents d'un écran d'affichage.

La deuxième LED 200 est configurée pour émettre un deuxième faisceau lumineux 210 étant, comme le premier faisceau lumineux 110, avantageusement configuré pour être principalement émis selon la direction transverse. Le deuxième faisceau lumineux 210 est par exemple omnidirectionnel et admet typiquement un profil lambertien.

La deuxième source de lumière 200 comprend au moins un deuxième nanofil actif 201 s'étendant depuis la face supérieure 20 du substrat 2, et préférentiellement une pluralité de deuxièmes nanofils actifs 201. Les deuxièmes nanofils actifs 201 forment de préférence un cristal photonique pouvant être décrit de la même façon que le cristal photonique formé par les premiers nanofils actifs 101. Les deuxièmes nanofils 201 sont avantageusement disposés selon des rangées orientées selon une première direction et/ou une deuxième direction. Ces rangées sont nommées deuxièmes rangées et deuxièmes rangées secondaires respectivement. Les deuxièmes rangées et les deuxièmes rangées secondaires sont respectivement au nombre de $N_{LED,x,2}$ et $N_{LED,y,2}$. Elles sont par ailleurs repérées à l'aide d'une indexation allant de 1 à $N_{LED,x,2}$ en s'éloignant de la première zone de transition et de 1 à $N_{LED,y,2}$ respectivement. Les deuxièmes rangées sont avantageusement séparées par des deuxièmes distances prises selon la première direction ayant une valeur sensiblement égale à une deuxième distance cible $P_{20,x}$. Il est entendu que du fait des imprécisions découlant des procédés de fabrication, la distance entre deux deuxièmes rangées voisines peut varier autour de la deuxième distance cible $p_{20,x}$. Les variations de la valeur de la distance entre deux deuxièmes rangées voisines dues aux aléas de fabrication peuvent être estimées à environ 10% de la valeur cible.

Comme pour les premiers nanofils 101, on définit pour chaque deuxième nanofil 201 un deuxième diamètre réel noté $\varphi_{2,n}$, n indexant les deuxièmes nanofils et variant donc de 1 à $N_2$, $N_2$ étant le nombre de premiers nanofils 101. Ce premier diamètre réel est de préférence tel que $0,9.\varphi_{20} < \varphi_{2,n} < 1,1.\varphi_{20}$, $\varphi_{20}$, étant un deuxième diamètre cible.

La zone de transition 1000 sépare la première LED 100 et la deuxième LED 200. Plusieurs configurations de la zone de transition sont envisageables. Par exemple, il est possible de prévoir qu'au sein de la zone de transition, et séparant donc la première LED 100 et la deuxième LED 200, se trouvent :

- la première sous-zone de transition 1100 telle que décrite précédemment bordant la première LED 100,
- éventuellement une deuxième sous-zone de transition 1200 bordant la deuxième LED 200,

- éventuellement une sous-zone seuil telle que décrite précédemment et séparant la première sous-zone de transition 1100 et la deuxième sous-zone de transition 1200.

Les caractéristiques de la première sous-zone de transition 1100 s'applique mutatis mutandis à la deuxième sous-zone de transition 1200.

Avantageusement, les premiers diamètres de transition et/ou les distances entre premières rangées de transition voisines varient progressivement :

- de la valeur cible des premiers diamètres, $\varphi_{10}$, des premiers nanofils 101 de la première LED 100, à la valeur cible des deuxièmes diamètres, $\varphi_{20}$, des deuxièmes nanofils 201 de la deuxième LED 200, les valeurs $\varphi_{10}$ et $\varphi_{20}$ étant prises par les diamètres des nanofils de transition 1001 des premières rangées de transition n°1 et $N_{trans,x,1}$ respectivement, et/ou
- de la première distance cible, $p_{10,x}$, à la deuxième distance cible, $p_{20,x}$, les valeurs $p_{10,x}$ et $p_{20,x}$ étant respectivement prises entre la première rangée de transition n°1 et la première rangée de transition n°2 d'une part et la première rangée de transition n°$N_{trans,x,1}$-1 et la première rangée de transition n° $N_{trans,x,1}$ d'autre part, respectivement.

La figure 2 illustre par exemple le cas où le diamètre des nanofils de transition 1001 varie de $\varphi_{10}$ à $\varphi_{20}$ lorsque l'on parcourt la zone de transition 1000 de la première LED 100 à la deuxième LED 200.

La figure 3 illustre notamment le cas où la distance entre deux premières rangées de transition successives varie de $p_{10,x}$ à $p_{20,x}$ lorsque l'on parcourt la zone de transition 1000 de la première LED 100 à la deuxième LED 200.

Cette variation de préférence continue voire monotone forme une transition douce entre les première et deuxième LED 100, 200. Cela permet d'éviter des ruptures de symétrie entre les différents réseaux de nanofils formant les première et deuxième LED 100, 200. Les effets de bord sont ainsi avantageusement limités ou supprimés.

Préférentiellement, cette variation des premiers diamètres de transition et/ou des distances entre premières rangées de transition voisines est linéaire.

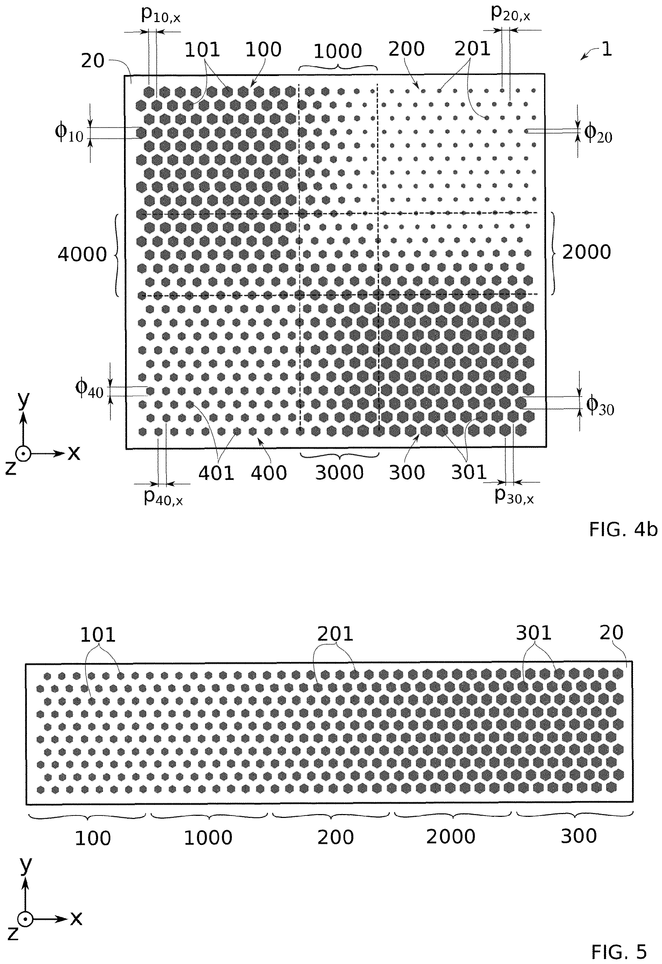

Les modes de réalisation décrits précédemment, dans lesquels le dispositif 1 comprend une zone de transition et respectivement une et deux LEDs, peuvent s'étendre à des dispositifs comprenant un nombre supérieur de LEDs et de zones de transition. Un dispositif à trois LEDs 100, 200, 300 et deux zones de transition 1000, 2000 séparant respectivement la première et deuxième LED 100, 200 d'une part et la deuxième et une troisième LED 200, 300 d'autre part, est par exemple illustré à la figure 5. Selon une possibilité, le dispositif comprend trois LEDs 100, 200, 300 et trois zones de transition 1000, 2000, 3000, la première zone de transition 1000 séparant les première et deuxième LEDs 100, 200, la deuxième zone de transition 2000 séparant les deuxième et troisième LEDs et la troisième zone de transition 3000 séparant les troisième et première LEDs. Ce mode de réalisation permet notamment de réaliser des pixels RGB constitué de trois sous-pixels R, G, B, correspondant aux trois LEDs 100, 200, 300, émettant respectivement dans le rouge (R désignant « red » c'est-à-dire rouge), le vert (G désignant « green » c'est-à-dire vert) et le bleu (B désignant « blue » c'est-à-dire bleu).

Il est également envisageable que le dispositif 1 comprenne quatre LEDs 100, 200, 300, 400 séparées par quatre zones de transition 1000, 2000, 3000, 4000 comme représenté sur la figure 4b.

Les caractéristiques des première et deuxième LEDs 100, 200 décrites précédemment s'appliquent mutatis mutandis aux troisième et quatrième LEDs 300, 400. Comme illustré à la figure 4b, ces dernières comprennent typiquement respectivement des troisièmes nanofils 301 et quatrième nanofils 401 présentant respectivement un troisième diamètre cible $\varphi_{30}$ et un quatrième diamètre cible $\varphi_{40}$ et ordonnés en rangées orientées selon la deuxième direction. Ces rangées sont typiquement elles-mêmes espacées selon la première direction par une troisième distance cible $p_{30,x}$ et une quatrième distance cible $p_{40,x}$, respectivement.

Les caractéristiques de la première zone de transition 1000 décrites précédemment s'appliquent mutatis mutandis aux trois zones de transition 2000, 3000, 4000.

Selon un mode de réalisation avantageux de la présente invention, au moins une partie des nanofils de la (des) zone(s) de transition sont des nanofils actifs et sont utilisés pour étendre la gamme de couleurs pouvant être rendues par le dispositif 1.

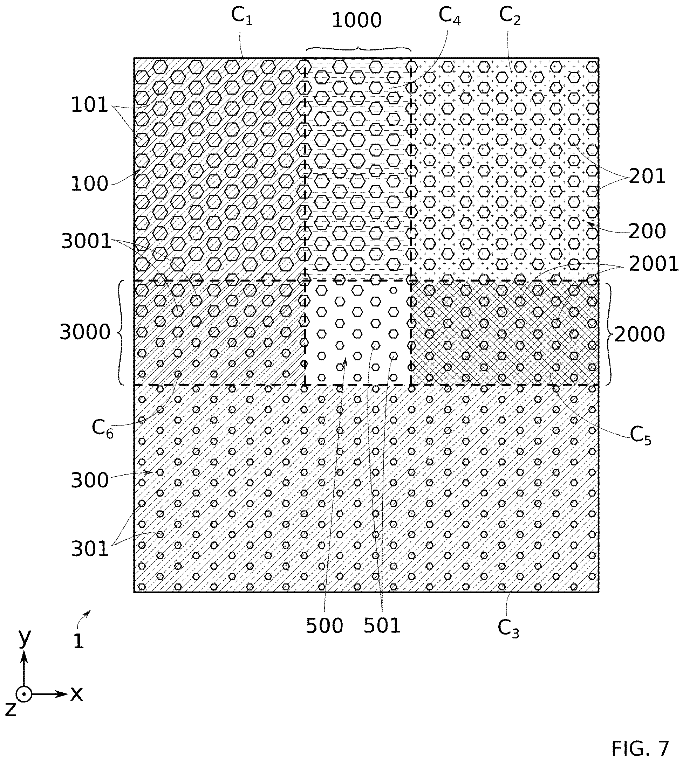

Les figures, et notamment les figures 6a, 6b et 7, illustrent ce mode de réalisation appliqué à un dispositif à quatre LEDs émettant trois couleurs natives (C1, C2 et C3), mais il est entendu que ce principe peut être appliqué à tout dispositif comprenant plus de deux LEDs.

Les couleurs usuellement émises par les sous-pixels d'un même pixel sont le rouge (C1 sur le diagramme de chromaticité illustré à la figure 6a), le vert (C2 sur le diagramme de chromaticité) et le bleu (C3 sur le diagramme de chromaticité). D'autres couleurs peuvent cependant être rendues à partir d'un tel pixel. Toutes les couleurs comprises dans le gamut 4 défini par les couleurs émises par les trois sous-pixels sur le diagramme de chromaticité du système colorimétrique CIE XYZ peuvent être obtenues par combinaisons linéaires des trois couleurs natives. Il est par exemple possible, en éteignant le sous-pixel émettant dans le bleu et par combinaison linéaire des faisceaux rouge et vert, de faire en sorte que la couleur perçue par un observateur soit jaune. Cependant, toutes les teintes du spectrum locus, c'est-à-dire l'ensemble des couleurs pures perceptibles par la vision humaine, ne sont pas comprises dans le gamut 4 caractérisant les teintes pouvant être générées par le pixel. Certaines teintes situées en dehors du gamut 4 pourraient pourtant être nécessaires pour rendre une image de façon fidèle. Les zones de transition peuvent avantageusement servir à atteindre ces teintes du spectrum locus 3 situées hors du gamut 4.

En effet, les paramètres caractérisant l'ensemble des nanofils de transition d'une zone de transition séparant deux LEDs peuvent être configurés pour que cette zone émette un faisceau dont la longueur d'onde se trouve en dehors du gamut 4. Parmi ces paramètres figure notamment le diamètre de chacun des nanofils de transition.

Il est par exemple envisageable que, sur plusieurs rangées consécutives, les nanofils de transition 1001 soient tous configurés pour émettre un faisceau à une même longueur d'onde dite longueur d'onde de transition $\lambda_{trans}$, distincte des longueurs d'onde émises par lesdites LEDs adjacentes. La longueur d'onde du faisceau global obtenu par la superposition des faisceaux émis par chacun de ces nanofils de transition 1001 est alors elle aussi de $\lambda_{trans}$.

Selon un autre mode de réalisation, on prévoit que le faisceau global à la longueur d'onde $\lambda_{trans}$ se situant en dehors du gamut 4 soit généré par un ensemble de nanofils de transition 1001. Cela est en effet rendu possible par un effet de moyennage des faisceaux individuels générés par chacun des nanofils de transition 1001 impliqués. Ces nanofils de transition 1001 peuvent par ailleurs tout à fait présenter des paramètres (pas, diamètres) variant progressivement, tel que décrit précédemment.

Dans tous les cas, la longueur d'onde de transition $\lambda_{trans}$ est choisie de sorte à être avantageuse dans le cadre de l'affichage d'images.

Comme mentionné précédemment, les premiers nanofils 101 de la première LED 100 et les premiers nanofils de transition 1001 de la première zone de transition 1000 sont avantageusement alimentés électriquement indépendamment les uns des autres, par des électrodes distinctes. Cela permet d'alimenter uniquement les premiers nanofils de transition 1001. Le dispositif 1 peut alors émettre uniquement la couleur correspondant à ladite zone de transition. La possibilité d'isoler cette couleur peut être particulièrement avantageux pour le rendu de certaines images.

Selon un mode de réalisation avantageux, on prévoit que l'ensemble des premiers nanofils de transition d'une sous-zone seuil telle que décrite plus haut et séparant une première LED 100 et une deuxième LED 200 soient configurés pour émettre une longueur d'onde $\lambda_{trans}$ distincte de $\lambda_1$ et de $\lambda_2$.

Selon un mode de réalisation particulièrement avantageux représenté à la figure 7, le dispositif 1 comprend une région intermédiaire 500 comprenant une pluralité de nanofils intermédiaires 501 configurés pour que la région intermédiaire émette un faisceau de lumière blanche. Ce mode de réalisation est tout particulièrement adapté aux dispositifs 1 comprenant trois ou quatre LEDs séparées deux à deux par des zones de transition. Comme représenté sur la figure 7, la région intermédiaire 500 est, dans cet exemple, bordée par la première, la deuxième et la troisième zone de transition 1000, 2000, 3000 ainsi que la troisième LED 300. Les nanofils intermédiaires 501 présentent notamment une variété de diamètres permettant d'émettre à une pluralité de longueurs d'onde réparties sensiblement sur l'ensemble du spectre visible. La région intermédiaire 500 génère ainsi avantageusement, par un effet de moyennage, un faisceau de lumière sensiblement blanche. Les diamètres des nanofils intermédiaires 501 bordant immédiatement chacune des zones de transition 1000, 2000, 3000 sont de plus choisis de sorte à éviter toute transition abrupte, sur le modèle d'une zone de transition telle que décrite précédemment. Il est à noter que le dimensionnement du réseau de nanofils de la région intermédiaire 500 (pas, diamètre), doit prendre en compte la valeur du courant injecté dans chacun des nanofils intermédiaires. La puissance lumineuse émise par ces nanofils intermédiaires 501 dépend en effet de ce courant, et même à courant constant, elle n'est pas égale d'un nanofils à l'autre lorsque ceux-ci émettent à des longueurs d'onde différentes. Le dimensionnement des nanofils intermédiaires 501 doit donc se faire en conséquence : l'obtention d'une lumière blanche dépend du nombre de nanofils intermédiaires 501 émettant à chaque longueur d'onde et de la puissance émise par chacun d'entre eux. Typiquement, la région intermédiaire 500 est alimenté par une unique électrode : le courant injecté est alors identique pour chacun des nanofils intermédiaires 501. Il est cependant envisageable que plusieurs électrodes soient prévues pour alimenter différents ensembles de nanofils intermédiaires 501. Cela permet d'ajuster plus précisément le dimensionnement des nanofils intermédiaires 501 et de faciliter l'obtention d'une lumière blanche.

Il est entendu que ce mode de réalisation s'applique à tout dispositif selon l'invention comprenant un nombre de LEDs supérieur à trois.

A travers les différents modes de réalisation décrits ci-dessus, il apparaît clairement que l'invention propose une solution efficace aux problèmes dus aux effets de bord autour des pixels et sous-pixels d'écrans d'affichage, ainsi qu'aux limitations actuelles du gamut de ces mêmes écrans.

L'invention n'est cependant pas limitée aux modes de réalisations précédemment décrits.

En particulier, le nombre, la forme et la disposition de chaque élément du dispositif peuvent être adaptés en fonction des besoins d'affichage.

L'étendue de la présente invention est telle que définie par les revendications qui suivent.

## Revendications

**1.** Dispositif optoélectronique (1) comprenant au moins :

- une première LED (100) s'étendant principalement dans un plan (xy) défini par une première direction (x) et une deuxième direction (y), ladite première LED (100) comprenant une pluralité de premiers nanofils (101) présentant des premiers diamètres ayant une valeur sensiblement égale à un premier diamètre cible $\varphi_{10}$ et organisés en $N_{LED,x,1}$ rangées orientées selon la deuxième direction (y), dites premières rangées, lesdites premières rangées étant séparées par des premières distances prises selon la première direction (x) ayant une valeur sensiblement égale à une première distance cible $p_{10,x}$, ladite première LED (100) étant configurée pour émettre un premier faisceau lumineux présentant principalement une première longueur d'onde $\lambda_1$, et

- une première zone de transition (1000) s'étendant principalement dans le plan (xy) et bordant au moins en partie ladite première LED (100), ladite première zone de transition (1000) comprenant une pluralité de premiers nanofils de transition (1001) présentant des premiers diamètres de transition et organisés en $N_{trans,x,1}$ rangées orientées selon la deuxième direction (y), dites premières rangées de transition et indexées selon une numérotation de 1 à $N_{trans,x,1}$ en s'éloignant de la première LED (100) selon la première direction (x), les premières rangées étant indexées selon une numérotation de 1 à $N_{LED,x,1}$ selon la première direction (x) en se rapprochant de la première zone de transition (1000),

le dispositif étant **caractérisé en ce que** la première zone de transition (1000) comprend une première sous-zone de transition (1100) formée par les $N_{sous-trans,1}$ premières rangées de transition, avec $2 \leq N_{sous-trans,1} \leq N_{trans,x,1}$, bordant la première LED (100), première sous-zone de transition (1100) dans laquelle :

- les premiers nanofils de transition (1001) sont tels que :

i. la valeur des premiers diamètres de transition des premiers nanofils de transition (1001) de la première rangée de transition n°1 varie dans une proportion inférieure à 5% du premier diamètre cible $\varphi_{10}$, et
ii. la valeur du premier diamètre de transition de chaque premier nanofil de transition (1001) de toute première rangée de transition n°i, i étant compris entre 2 et $N_{sous-trans,1}$, varie dans une proportion comprise entre 3% et 13% de la valeur du premier diamètre de transition du premier nanofil de transition (1001) de la première rangée de transition n°i-1 lui étant le plus proche,
et/ou

- les premiers nanofils de transition (1001) sont tels que :

i. la première rangée n°$N_{LED,x,1}$ et la première rangée de transition n°1 étant séparées selon la première direction x par une première distance d'interface $d_{interface,1}$, la première distance d'interface $d_{interface,1}$ et la distance selon la première direction (x) entre la première rangée de transition n°1 et la première rangée de transition n°2 varient dans une proportion comprise entre 2% et 4% de la distance selon la première direction (x) entre la première rangée n°$N_{LED,x,1}$-1 et la première rangée n°$N_{LED,x,1}$ et la première distance d'interface dinterface,1 respectivement, et
ii. la distance selon la première direction (x) entre toute première rangée de transition n°i et la première rangée de transition n°i+1 varie dans une proportion comprise entre 2% et 4% de la distance selon la première direction (x) entre la première rangée de transition n°i-1 et la première rangée de transition n°i, i étant compris entre 2 et $N_{sous-trans,1}$-1.

2. Dispositif optoélectronique (1) selon la revendication précédente dans lequel les premiers diamètres de transition des premiers nanofils de transition (1001) d'une même première rangée de transition sont égaux.

3. Dispositif optoélectronique (1) selon l'une quelconque des revendications précédentes dans lequel :

- la valeur des premiers diamètres de transition des premiers nanofils de transition (1001) des premières rangées de transition présente une évolution strictement croissante ou strictement décroissante sur au moins trois premières rangées de transition successives en s'éloignant de la première LED (100), et/ou
- la distance entre deux premières rangées de transition successives en s'éloignant de la première LED (100) présente une évolution strictement croissante ou strictement décroissante sur au moins trois premières rangées de transition successives en s'éloignant de la première LED (100).

4. Dispositif optoélectronique (1) selon la revendication précédente dans lequel :

- la valeur des premiers diamètres de transition des premiers nanofils de transition (1001) des premières rangées de transition présente une évolution linéaire sur au moins trois premières rangées de transition successives en s'éloignant de la première LED (100), et/ou
- la distance entre deux premières rangées de transition successives en s'éloignant de la première LED (100) présente une évolution linéaire sur au moins trois premières rangées de transition successives en s'éloignant de la première LED (100).

5. Dispositif optoélectronique (1) selon la revendication précédente dans lequel les premiers nanofils (101) et les premiers nanofils de transition (1001) sont en outre organisés en rangées selon la première direction (x).

6. Dispositif optoélectronique (1) selon l'une quelconque des revendications précédentes dans lequel la première sous-zone de transition (1100) s'étend sur au moins trois rangées, de préférence au moins cinq rangées, de premiers nanofils de transition (1001).

7. Dispositif optoélectronique (1) selon l'une quelconque des revendications précédentes dans lequel la première sous-zone de transition (1100) présente une surface $S_{1000}$ et la première LED (100) présente une surface $S_{100}$ telles que $S_{100}/5 < S_{1000} < S_{100}/2$.

8. Dispositif optoélectronique (1) selon l'une quelconque des revendications précédentes dans lequel les premiers nanofils (101) d'une part et les premiers nanofils de transition (1001) d'autre part sont alimentés par des contacts électriques distincts.

9. Dispositif optoélectronique (1) selon l'une quelconque des revendications précédentes comprenant en outre :

- une deuxième LED (200) s'étendant principalement dans le plan (xy), ladite deuxième LED (200) comprenant une pluralité de deuxièmes nanofils (201) présentant des deuxièmes diamètres ayant une valeur sensiblement égale à un deuxième diamètre cible $\varphi_{20}$ et organisés en $N_{LED,x,2}$ rangées orientées selon la deuxième direction (y), dites deuxièmes rangées, et indexées selon une numérotation de 1 à $N_{LED,x,2}$ en s'éloignant de la première zone de transition (1000) selon la première direction (x), lesdites deuxièmes rangées étant séparées par des premières distances prises selon la première direction (x) ayant une valeur sensiblement égale à une deuxième distance cible $p_{20,x}$, ladite deuxième LED (200) étant configurée pour émettre un deuxième faisceau lumineux présentant principalement une deuxième longueur d'onde $\lambda_2$,

lesdites première et deuxième LEDs (100, 200) étant séparées au moins par la première zone de transition (1000).

10. Dispositif optoélectronique (1) selon la revendication précédente dans lequel $N_{sous\text{-}trans,1} = N_{trans,x,1}$ et dans lequel :

   - la valeur des premiers diamètres de transition des premiers nanofils de transition (1001) de la première rangée de transition n°$N_{sous\text{-}trans,1}$ varie dans une proportion inférieure à 5% du deuxième diamètre cible $\varphi_{20}$, et/ou
   - la deuxième rangée n°1 et la première rangée de transition n°$N_{sous\text{-}trans,1}$ étant séparées selon la première direction (x) d'une deuxième distance d'interface $d_{interface,2}$,
   - la distance selon la première direction (x) entre la première rangée de transition n°$N_{sous\text{-}trans,1}$ et la première rangée de transition n°$N_{sous\text{-}trans,1}$-1 varie dans une proportion comprise entre 2% et 4% de la deuxième distance d'interface $d_{interface,2}$.

11. Dispositif optoélectronique (1) selon la revendication 9 dans lequel la première zone de transition (1000) comprend une deuxième sous-zone (1200) de transition formée par les premières rangées de transition n°$N_{sous\text{-}trans,2}$ à $N_{trans,x,1}$, avec $N_{sous\text{-}trans,1} \leq N_{sous\text{-}trans,2} < N_{trans,x,1}$, deuxième sous-zone (1200) de transition dans laquelle :

   - les premiers nanofils de transition (1001) sont tels que :

     i. la valeur des premiers diamètres de transition des premiers nanofils de transition (1001) de la première rangée de transition n°$N_{trans,x,1}$ varie dans une proportion inférieure à 5% du deuxième diamètre cible $\varphi_{20}$, et
     ii. la valeur des premiers diamètres de transition des premier nanofil de transition (1001) de toute première rangée de transition n°i, i étant compris entre $N_{sous\text{-}trans,2}$ et $N_{trans,x,1}$-1 varie dans une proportion comprise entre 3% et 13% de la valeur des premiers diamètres de transition des premiers nanofils de transition (1001) de la première rangée de transition n°i+1,
     et/ou

   - les premiers nanofils de transition (1001) sont tels que :

     i. la deuxième rangée n°1 et la première rangée de transition n°$N_{trans,x,1}$ étant séparées selon la première direction x d'une deuxième distance d'interface $d_{interface,2}$, la distance selon la première direction (x) entre la première rangée de transition n°$N_{trans,x,1}$ et la première rangée de transition n°$N_{trans,x,1}$-1 et la deuxième distance d'interface $d_{interface,2}$ varient dans une proportion comprise entre 2% et 4% de la deuxième distance d'interface $d_{interface,2}$ et de la distance selon la première direction (x) entre la deuxième rangée n°1 et la deuxième rangée n°2 respectivement,
     ii. la distance selon la première direction (x) entre toute première rangée de transition n°i et la première rangée de transition n°i-1 varie dans une proportion comprise entre 2% et 4% de la distance selon la première direction (x) entre la première rangée de transition n°i et la première rangée de transition n°i+1, i étant compris entre $N_{trans,x,1}$-1 et $N_{sous\text{-}trans,2}$+1.

12. Dispositif optoélectronique (1) selon la revendication précédente dans lequel :

   - la valeur des premiers diamètres de transition des premiers nanofils de transition (1001) des premières rangées de transition présente une évolution strictement croissante ou strictement décroissante sur au moins trois premières rangées de transition successives en s'éloignant de la deuxième LED (200), et/ou
   - la distance entre deux premières rangées de transition successives en s'éloignant de la première LED (100) présente une évolution strictement croissante ou strictement décroissante sur au moins trois premières rangées de transition successives en s'éloignant de la deuxième LED (200).

13. Dispositif optoélectronique (1) selon la revendication précédente dans lequel :

   - la valeur des premiers diamètres de transition des premiers nanofils de transition (1001) des premières rangées de transition présente une évolution linéaire sur au moins trois premières rangées de transition successives en s'éloignant de la deuxième LED (200), et/ou
   - la distance entre deux premières rangées de transition successives en s'éloignant de la première LED (100) présente une évolution linéaire sur au moins trois premières rangées de transition successives en s'éloignant de la deuxième LED (200).

**14.** Dispositif optoélectronique (1) selon l'une quelconque des revendications précédentes dans lequel au moins une partie des premiers nanofils de transition (1001) comprennent une région active (1002) configurée pour émettre un premier faisceau lumineux de transition qui présente principalement une première longueur d'onde de transition $\lambda_{trans,1}$, avec $\lambda_{trans,1} \neq \lambda_1$ et $\lambda_{trans,1} \neq \lambda_2$.

**15.** Dispositif optoélectronique (1) selon l'une quelconque des revendications 9 à 14 dans lequel :

- les premiers nanofils (101) sont organisés en $N_{LED,y,1}$ rangées orientées selon la première direction (x), dites premières rangées secondaires, indexées selon une numérotation de 1 à $N_{LED,y,1}$ et séparées par des premières distances secondaires prises selon la deuxième direction (y) ayant une valeur sensiblement égale à une première distance secondaire cible $p_{10,y}$, et
- les deuxièmes nanofils (201) sont organisés en $N_{LED,y,2}$ rangées orientées selon la première direction (x), dites deuxièmes rangées secondaires et indexées selon une numérotation de 1 à $N_{LED,y,2}$ et séparées par des deuxièmes distances secondaires prises selon la deuxième direction (y) ayant une valeur sensiblement égale à une deuxième distance secondaire cible $p_{20,y}$.

**16.** Dispositif optoélectronique (1) selon la revendication précédente comprenant en outre :

- une troisième LED (300) s'étendant principalement dans le plan (xy), ladite troisième LED (300) comprenant une pluralité de troisièmes nanofils (301) présentant des troisièmes diamètres ayant une valeur sensiblement égale à un troisième diamètre cible $\varphi_{30}$ et organisés en $N_{LED,x,3}$ rangées orientées selon la deuxième direction (y), dites troisièmes rangées et en $N_{LED,y,3}$ rangées orientées selon la première direction (x), dites troisièmes rangées secondaires, ladite troisième LED (300) étant configurée pour émettre un troisième faisceau lumineux présentant principalement une troisième longueur d'onde $\lambda_3$,
- une deuxième zone de transition (2000) s'étendant principalement dans le plan (xy) et bordant au moins en partie ladite deuxième LED (200) et ladite troisième LED (300), ladite deuxième zone de transition (2000) comprenant une pluralité de deuxièmes nanofils de transition (2001) présentant des deuxièmes diamètres de transition et organisés en $N_{trans,y,2}$ rangées orientées selon la première direction (x), dites deuxièmes rangées de transition secondaires et indexées selon une numérotation de 1 à $N_{trans,y,2}$ en se rapprochant de la deuxième LED (200) selon la deuxième direction (y),
- une troisième zone de transition (3000) s'étendant principalement dans le plan (xy) et bordant au moins en partie ladite troisième LED (300) et ladite première LED (100), ladite troisième zone de transition (3000) comprenant une pluralité de troisièmes nanofils de transition (3001) présentant des troisièmes diamètres de transition et organisés en $N_{trans,y,3}$ rangées orientées selon la première direction (x), dites troisièmes rangées de transition secondaires et indexées selon une numérotation de 1 à $N_{trans,y,3}$ en se rapprochant de la première LED (100) selon la deuxième direction (y),

lesdites deuxième et troisième LEDs (200, 300) étant séparées par la deuxième zone de transition (2000), lesdites troisième et première LEDs (300, 100) étant séparées par la troisième zone de transition (3000), dans lequel les deuxièmes nanofils de la deuxième zone de transition (2000) sont tels que :

i. la valeur des deuxièmes diamètres de transition des deuxièmes nanofils de transition (2001) de la deuxième rangée de transition n°1 varie dans une proportion inférieure à 5% du troisième diamètre cible $\varphi_{30}$, et

ii. la valeur du deuxième diamètre de transition de chaque deuxième nanofil de transition (2001) de toute deuxième rangée de transition secondaire n°i, i étant compris entre 2 et $N_{trans,y,2}$, varie dans une proportion comprise entre 3% et 13% de la valeur du deuxième diamètre de transition du deuxième nanofil de transition (2001) de la deuxième rangée de transition secondaire n°i-1 lui étant le plus proche, et

iii. la valeur des deuxièmes diamètres de transition des deuxièmes nanofils de transition (2001) de la deuxième rangée de transition n°$N_{trans,y,2}$ varie dans une proportion inférieure à 5% du deuxième diamètre cible $\varphi_{20}$,
et/ou

i. la deuxième rangée secondaire n°1 et la deuxième rangée de transition secondaire n°$N_{trans,y,2}$ étant séparées selon la deuxième direction (y) d'une troisième distance d'interface $d_{interface,3}$, la troisième distance d'interface $d_{interface,3}$ et la distance selon la deuxième direction (y) entre la deuxième rangée de transition secondaire n°$N_{trans,y,2}$ et la deuxième rangée de transition secondaire n° $N_{trans,y,2}$-1 varient dans une proportion comprise entre 2% et 4% de la distance selon la deuxième direction (y) entre la deuxième rangée de transition secondaire n°$N_{trans,y,2}$ et la deuxième rangée de transition secondaire n°$N_{trans,y,2}$-1 et la troisième distance d'interface $d_{interface,3}$ respectivement,

ii. la distance selon la deuxième direction (y) entre toute deuxième rangée de transition secondaire n°i et la deuxième rangée de transition secondaire n°i+1 varie dans une proportion comprise entre 2% et 4% de la distance selon la deuxième direction (y) entre la deuxième rangée de transition secondaire n°i-1 et la deuxième rangée de transition secondaire n°i, i étant compris entre 2 et $N_{trans,y,2}$-1, et

iii. la troisième rangée secondaire n°$N_{LED,y,3}$ et la deuxième rangée de transition secondaire n°1 étant séparées selon la deuxième direction (y) d'une quatrième distance d'interface $d_{interface,4}$, la quatrième distance d'interface $d_{interface,4}$ et la distance selon la deuxième direction (y) entre la deuxième rangée de transition secondaire n°2 et la deuxième rangée de transition secondaire n°1 varient dans une proportion comprise entre 2% et 4% de la distance selon la deuxième direction (y) entre la troisième rangée secondaire n°$N_{LED,y,3}$ et la troisième rangée secondaire n°$N_{LED,y,3}$-1 et la quatrième distance d'interface $d_{interface,4}$ respectivement,

et dans lequel les troisièmes nanofils de la troisième zone de transition (3000) sont tels que :

i. la valeur des troisièmes diamètres de transition des troisièmes nanofils de transition (3001) de la troisième rangée de transition n°1 varie dans une proportion inférieure à 5% du troisième diamètre cible $\varphi_{30}$, et

ii. la valeur du troisième diamètre de transition de chaque troisième nanofil de transition (3001) de toute troisième rangée de transition secondaire n°i, i étant compris entre 2 et $N_{trans,y,3}$, varie dans une proportion comprise entre 3% et 13% de la valeur du troisième diamètre de transition du troisième nanofil de transition (3001) de la troisième rangée de transition secondaire n°i-1 lui étant le plus proche, et

iii. la valeur des troisièmes diamètres de transition des troisièmes nanofils de transition (3001) de la troisième rangée de transition n°$N_{trans,y,3}$ varie dans une proportion inférieure à 5% du premier diamètre cible $\varphi_{10}$,

et/ou

i. la première rangée secondaire n°1 et la troisième rangée de transition secondaire n°$N_{trans,y,3}$ étant séparées selon la deuxième direction (y) d'une sixième distance d'interface $d_{interface,6}$, la sixième distance d'interface $d_{interface,6}$ et la distance selon la deuxième direction (y) entre la troisième rangée de transition secondaire n°$N_{trans,y,3}$ et la troisième rangée de transition secondaire n°$N_{trans,y,3}$-1 varient dans une proportion comprise entre 2% et 4% de la distance selon la deuxième direction (y) entre la troisième rangée de transition secondaire n°$N_{trans,y,3}$ et la troisième rangée de transition secondaire n°$N_{trans,y,3}$-1 et la sixième distance d'interface $d_{interface,3}$ respectivement,

ii. la distance selon la deuxième direction (y) entre toute troisième rangée de transition secondaire n°i et la troisième rangée de transition secondaire n°i+1 varie dans une proportion comprise entre 2% et 4% de la distance selon la deuxième direction (y) entre la troisième rangée de transition secondaire n°i-1 et la troisième rangée de transition secondaire n°i, i étant compris entre 2 et $N_{trans,y,3}$-1, et

iii. la troisième rangée secondaire n°$N_{LED,y,3}$ et la troisième rangée de transition secondaire n°1 étant séparées selon la deuxième direction (y) d'une cinquième distance d'interface $d_{interface,5}$, la cinquième distance d'interface $d_{interface,5}$ et la distance selon la deuxième direction (y) entre la troisième rangée de transition secondaire n°2 et la troisième rangée de transition secondaire n°1 varient dans une proportion comprise entre 2% et 4% de la distance selon la deuxième direction (y) entre la troisième rangée secondaire n°$N_{LED,y,3}$ et la troisième rangée secondaire n° $N_{LED,y,3}$-1 et la quatrième distance d'interface $d_{interface,4}$ respectivement.

**Patentansprüche**

1. Optoelektronische Vorrichtung (1), die mindestens Folgendes umfasst:

- eine erste LED (100), die sich überwiegend in einer Ebene (xy) erstreckt, die durch eine erste Richtung (x) und eine zweite Richtung (y) definiert ist, wobei die erste LED (100) eine Vielzahl von ersten Nanodrähten (101) umfasst, die erste Durchmesser mit einem Wert aufweisen, der im Wesentlichen gleich einem ersten Zieldurchmesser $\varphi_{10}$ ist, und die in $N_{LED,x,1}$ Reihen angeordnet sind, die in der zweiten Richtung (y) ausgerichtet sind und als erste Reihen bezeichnet werden, wobei die ersten Reihen durch erste Abstände, die entlang der ersten Richtung (x) genommen werden, mit einem Wert getrennt sind, der im Wesentlichen gleich einem ersten Zielabstand $p_{10,x}$ ist, wobei die erste LED (100) dazu konfiguriert ist, einen ersten Lichtstrahl zu emittieren, der überwiegend eine erste Wellenlänge $\lambda_1$ aufweist, und

- eine erste Übergangszone (1000), die sich überwiegend in der Ebene (xy) erstreckt und mindestens teilweise an die erste LED (100) angrenzt, wobei die erste Übergangszone (1000) eine Vielzahl von ersten Übergangsnanodrähten (1001) umfasst, die erste Übergangsdurchmesser aufweisen und in $N_{übergang,x,1}$ Reihen angeordnet sind, die in der zweiten Richtung (y) ausgerichtet sind, als erste Übergangsreihen bezeichnet werden und gemäß einer Numerierung von 1 bis $N_{übergang,x,1}$ indiziert sind, während sie sich von der ersten LED (100) in die erste Richtung (x) wegbewegen, wobei die ersten Reihen gemäß einer Numerierung von 1 bis $N_{LED,x,1}$ in der ersten Richtung (x) indiziert sind, während sie sich der ersten Übergangszone (1000) nähern,

wobei die Vorrichtung **dadurch gekennzeichnet ist, dass** die erste Übergangszone (1000) eine erste Übergangsunterzone (1100) umfasst, die durch die ersten $N_{unter-übergang,1}$ Übergangsreihen gebildet wird, wobei $2 \leq N\,N_{unter-übergang,1} \leq N_{übergang,x,1}$, und an die erste LED (100) angrenzt, wobei in der ersten Übergangsunterzone (1100):

- die ersten Übergangsnanodrähte (1001) derart sind, dass:

i. der Wert der ersten Übergangsdurchmesser der ersten Übergangsnanodrähte (1001) der ersten Übergangsreihe Nr. 1 in einem Verhältnis von weniger als 5 % des ersten Zieldurchmessers $\varphi_{10}$ variiert, und
ii. der Wert des ersten Übergangsdurchmessers jedes ersten Übergangsnanodrahts (1001) jeder ersten Übergangsreihe Nr. i, wobei i zwischen 2 und N $N_{unter-übergang,1}$ liegt, in einem Verhältnis zwischen 3 % und 13 % des Werts des ersten Übergangsdurchmessers des ersten Übergangsnanodrahts (1001) der ersten Übergangsreihe Nr. i-1, der ihm am nächsten liegt, variiert,
und/oder

- die ersten Übergangsnanodrähte (1001) derart sind, dass:

i. die erste Reihe Nr. $N_{LED,x,1}$ und die erste Übergangsreihe Nr. 1 in der ersten Richtung x durch einen ersten Grenzflächenabstand $d_{interface,1}$ getrennt sind, wobei der erste Grenzflächenabstand $d_{interface,1}$ und der Abstand in der ersten Richtung (x) zwischen der ersten Übergangsreihe Nr. 1 und der ersten Übergangsreihe Nr. 2 in einem Verhältnis zwischen 2 % und 4 % des Abstands in der ersten Richtung (x) zwischen der ersten Reihe Nr. $N_{LED,x,1}$-1 bzw. der ersten Reihe Nr. $N_{LED,x,1}$ und dem ersten Grenzflächenabstand $d_{interface,1}$ variieren,
ii. der Abstand in der ersten Richtung (x) zwischen jeder ersten Übergangsreihe Nr. i und der ersten Übergangsreihe Nr. i+1 in einem Verhältnis zwischen 2 % und 4 % des Abstands in der ersten Richtung (x) zwischen der ersten Übergangsreihe Nr. i-1 und der ersten Übergangsreihe Nr. i variiert, wobei i zwischen 2 und N $N_{unter-übergang,1}$-1 liegt.

2. Optoelektronische Vorrichtung (1) nach dem vorhergehenden Anspruch, wobei die ersten Übergangsdurchmesser der ersten Übergangsnanodrähte (1001) in einer gleichen ersten Übergangsreihe gleich sind.

3. Optoelektronische Vorrichtung (1) nach einem der vorhergehenden Ansprüche, wobei:

- der Wert der ersten Übergangsdurchmesser der ersten Übergangsnanodrähte (1001) der ersten Übergangsreihen über mindestens drei aufeinanderfolgende erste Übergangsreihen, die sich von der ersten LED (100) wegbewegen, einen streng zunehmenden oder streng abnehmenden Verlauf aufweist, und/oder
- der Abstand zwischen zwei ersten aufeinanderfolgenden Übergangsreihen, die sich von der ersten LED (100) wegbewegen, über mindestens drei erste aufeinanderfolgenden Übergangsreihen, die sich von der ersten LED (100) wegbewegen, einen streng zunehmenden oder streng abnehmenden Verlauf aufweist.

**4.** Optoelektronische Vorrichtung (1) nach dem vorhergehenden Anspruch, wobei:

- der Wert der ersten Übergangsdurchmesser der ersten Übergangsnanodrähte (1001) der ersten Übergangsreihen über mindestens drei aufeinanderfolgende erste Übergangsreihen, die sich von der ersten LED (100) wegbewegen, einen linearen Verlauf aufweist, und/oder
- der Abstand zwischen zwei ersten aufeinanderfolgenden Übergangsreihen, die sich von der ersten LED (100) wegbewegen, über mindestens drei erste aufeinanderfolgende Übergangsreihen, die sich von der ersten LED (100) wegbewegen, einen linearen Verlauf aufweist.

**5.** Optoelektronische Vorrichtung (1) nach dem vorhergehenden Anspruch, wobei die ersten Nanodrähte (101) und die ersten Übergangsnanodrähte (1001) ferner in Reihen in der ersten Richtung (x) angeordnet sind.

**6.** Optoelektronische Vorrichtung (1) nach einem der vorhergehenden Ansprüche, wobei sich die erste Übergangsunterzone (1100) über mindestens drei Reihen, vorzugsweise mindestens fünf Reihen, von ersten Übergangsnanodrähten (1001) erstreckt.

**7.** Optoelektronische Vorrichtung (1) nach einem der vorhergehenden Ansprüche, wobei die erste Übergangsunterzone (1100) eine Oberfläche $S_{1000}$ aufweist und die erste LED (100) eine Oberfläche $S_{100}$ aufweist, so dass $S_{100}/5 < S_{1000} < S_{100}/2$.

**8.** Optoelektronische Vorrichtung (1) nach einem der vorhergehenden Ansprüche, wobei die ersten Nanodrähte (101) einerseits und die ersten Übergangsnanodrähte (1001) andererseits über separate elektrische Kontakte mit Strom versorgt werden.

**9.** Optoelektronische Vorrichtung (1) nach einem der vorhergehenden Ansprüche, die ferner Folgendes umfasst:

- eine zweite LED (200), die sich überwiegend in der Ebene (xy) erstreckt, wobei die zweite LED (200) eine Vielzahl von zweiten Nanodrähten (201) umfasst, die zweite Durchmesser mit einem Wert aufweisen, der im Wesentlichen gleich einem zweiten Zieldurchmesser $\varphi_{20}$ ist, und die in $N_{LED,x,2}$ Reihen angeordnet sind, die in der zweiten Richtung (y) ausgerichtet sind, als zweite Reihen bezeichnet werden und gemäß einer Nummerierung von 1 bis $N_{LED,x,2}$ indiziert sind, während sie sich von der ersten Übergangszone (1000) in der ersten Richtung (x) wegbewegen, wobei die zweiten Reihen durch erste Abstände getrennt sind, die in der ersten Richtung (x) genommen werden und einen Wert aufweisen, der im Wesentlichen gleich einem zweiten Zielabstand $p_{20,x}$ ist, wobei die zweite LED (200) dazu konfiguriert ist, einen zweiten Lichtstrahl zu emittieren, der überwiegend eine zweite Wellenlänge $\lambda_2$ aufweist,

wobei die erste und die zweite LED (100, 200) mindestens durch die erste Übergangszone (1000) getrennt sind.

**10.** Optoelektronische Vorrichtung (1) nach dem vorhergehenden Anspruch, wobei N $N_{unter-übergang,1}$ = $N_{übergang,x,1}$ und wobei:

- der Wert der ersten Übergangsdurchmesser der ersten Übergangsnanodrähte (1001) der ersten Übergangsreihe Nr. N $N_{unter-übergang,1}$ in einem Verhältnis von weniger als 5 % des zweiten Zieldurchmessers $\varphi_{20}$ variiert, und/oder
- die zweite Reihe Nr. 1 und die erste Übergangsreihe Nr. N $N_{unter-übergang,1}$ in der ersten Richtung (x) durch einen zweiten Grenzflächenabstand $d_{interface,2}$ getrennt sind,
- der Abstand in der ersten Richtung (x) zwischen der ersten Übergangsreihe Nr. N $N_{unter-übergang,1}$ und der ersten Übergangsreihe Nr. N $N_{unter-übergang,1}$-1 in einem Verhältnis zwischen 2 % und 4 % des zweiten Grenzflächenabstands $d_{interface,2}$ variiert.

**11.** Optoelektronische Vorrichtung (1) nach Anspruch 9, wobei die erste Übergangszone (1000) eine zweite Übergangsunterzone (1200) umfasst, die durch die ersten Übergangsreihen Nr. N $N_{unter-übergang,2}$ bis $N_{übergang,x,1}$ gebildet wird, wobei N $N_{unter-übergang,1}$ ≤ N $N_{unter-übergang,2}$ < $N_{übergang,x,1}$, wobei in der zweiten Übergangsunterzone (1200):

- die ersten Übergangsnanodrähte (1001) derart sind, dass:

  i. der Wert der ersten Übergangsdurchmesser der ersten Übergangsnanodrähte (1001) der ersten Übergangsreihe Nr. $N_{übergang,x,1}$ in einem Verhältnis von weniger als 5 % des zweiten Zieldurchmessers $\varphi_{20}$ variiert, und

  ii. der Wert der ersten Übergangsdurchmesser des ersten Übergangsnanodrahts (1001) jeder ersten Übergangsreihe Nr. i, wobei i zwischen N $N_{unter-übergang,2}$ und $N_{übergang,x,1}$-1 liegt, in einem Verhältnis zwischen 3 % und 13 % des Werts der ersten Übergangsdurchmesser der ersten Übergangsnanodrähte (1001) der ersten Übergangsreihe Nr. i+1 variiert,

und/oder

- die ersten Übergangsnanodrähte (1001) derart sind, dass:

i. die zweite Reihe Nr. 1 und die erste Übergangsreihe Nr. $N_{übergang,x,1}$ in der ersten Richtung x durch einen zweiten Grenzflächenabstand $d_{interface,2}$ getrennt sind, wobei der Abstand in der ersten Richtung (x) zwischen der ersten Übergangsreihe Nr. $N_{übergang,x,1}$ und der ersten Übergangsreihe Nr. $N_{übergang,x,1}$-1 und der zweite Grenzflächenabstand $d_{interface,2}$ in einem Verhältnis zwischen 2 % und 4 % des zweiten Grenzflächenabstands $d_{interface,2}$ und des Abstands in der ersten Richtung (x) zwischen der zweiten Reihe Nr. 1 bzw. der zweiten Reihe Nr. 2 variieren,
ii. der Abstand in der ersten Richtung (x) zwischen jeder ersten Übergangsreihe Nr. i und der ersten Übergangsreihe Nr. i-1 in einem Verhältnis zwischen 2 % und 4 % des Abstands in der ersten Richtung (x) zwischen der ersten Übergangsreihe Nr. i und der ersten Übergangsreihe Nr. i+1 variiert, wobei i zwischen $N_{übergang,x,1}$-1 und N $N_{unter-übergang,2}$+1 liegt.

12. Optoelektronische Vorrichtung (1) nach dem vorhergehenden Anspruch, wobei:

- der Wert der ersten Übergangsdurchmesser der ersten Übergangsnanodrähte (1001) der ersten Übergangsreihen über mindestens drei aufeinanderfolgende erste Übergangsreihen, die sich von der zweiten LED (200) wegbewegen, einen streng zunehmenden oder streng abnehmenden Verlauf aufweist, und/oder
- der Abstand zwischen zwei ersten aufeinanderfolgenden Übergangsreihen, die sich von der ersten LED (100) wegbewegen, über mindestens drei erste aufeinanderfolgende Übergangsreihen, die sich von der zweiten LED (200) wegbewegen, einen streng zunehmenden oder streng abnehmenden Verlauf aufweist.

13. Optoelektronische Vorrichtung (1) nach dem vorhergehenden Anspruch, wobei:

- der Wert der ersten Übergangsdurchmesser der ersten Übergangsnanodrähte (1001) der ersten Übergangsreihen über mindestens drei aufeinanderfolgende erste Übergangsreihen, die sich von der zweiten LED (200) wegbewegen, einen linearen Verlauf aufweist, und/oder
- der Abstand zwischen zwei ersten aufeinanderfolgenden Übergangsreihen, die sich von der ersten LED (100) wegbewegen, über mindestens drei erste aufeinanderfolgende Übergangsreihen, die sich von der zweiten LED (200) wegbewegen, einen linearen Verlauf aufweist.

14. Optoelektronische Vorrichtung (1) nach einem der vorhergehenden Ansprüche, wobei mindestens ein Teil der ersten Übergangsnanodrähte (1001) einen aktiven Bereich (1002) umfasst, der dazu konfiguriert ist, einen ersten Übergangslichtstrahl zu emittieren, der überwiegend eine erste Übergangswellenlänge $\lambda_{übergang,1}$ aufweist, wobei $\lambda_{übergang,1} \neq \lambda_1$ und $\lambda_{übergang,1} \neq \lambda_2$.

15. Optoelektronische Vorrichtung (1) nach einem der Ansprüche 9 bis 14, wobei:

- die ersten Nanodrähte (101) in $N_{LED,y,1}$ Reihen angeordnet sind, die in der ersten Richtung (x) ausgerichtet sind, als erste sekundäre Reihen bezeichnet werden, gemäß einer Nummerierung von 1 bis $N_{LED,y,1}$ indiziert und durch erste sekundäre Abstände getrennt sind, die in der zweiten Richtung (y) genommen werden und einen Wert aufweisen, der im Wesentlichen gleich einem ersten sekundären Zielabstand $p_{10,y}$ ist, und
- die zweiten Nanodrähte (201) in $N_{LED,y,2}$ Reihen angeordnet sind, die in der ersten Richtung (x) ausgerichtet sind, als zweite sekundäre Reihen bezeichnet werden und gemäß einer Nummerierung von 1 bis $N_{LED,y,2}$ indiziert und durch zweite sekundäre Abstände getrennt sind, die in der zweiten Richtung (y) genommen werden und einen Wert aufweisen, der im Wesentlichen gleich einem zweiten sekundären Zielabstand $p_{20,y}$ ist.

16. Optoelektronische Vorrichtung (1) nach dem vorhergehenden Anspruch, die ferner Folgendes umfasst:

- eine dritte LED (300), die sich überwiegend in der Ebene (xy) erstreckt, wobei die dritte LED (300) eine Vielzahl von dritten Nanodrähten (301) umfasst, die dritte Durchmessern mit einem Wert aufweisen, der im Wesentlichen gleich einem dritten Zieldurchmesser $\varphi_{30}$ ist, und die in $N_{LED,x,3}$ Reihen, die in der zweiten Richtung (y) ausgerichtet sind und als dritte Reihen bezeichnet werden, und in $N_{LED,y,3}$ Reihen angeordnet sind, die in der ersten Richtung (x) ausgerichtet sind und als dritte sekundäre Reihen bezeichnet werden, wobei die dritte LED (300) dazu konfiguriert ist, einen dritten Lichtstrahl zu emittieren, der überwiegend eine dritte Wellenlänge $\lambda_3$ aufweist,
- eine zweite Übergangszone (2000), die sich überwiegend in der Ebene (xy) erstreckt und mindestens teilweise an die zweite LED (200) und die dritte LED (300) angrenzt, wobei die zweite Übergangszone (2000) eine Vielzahl von zweiten Übergangsnanodrähten (2001) umfasst, die zweite Übergangsdurchmesser aufweist und in $N_{\text{übergang,y,2}}$ Reihen angeordnet sind, die in der ersten Richtung (x) ausgerichtet sind, als zweite sekundäre Übergangsreihen bezeichnet werden und gemäß einer Nummerierung von 1 bis $N_{\text{übergang,y,2}}$ indiziert sind, während sie sich der zweiten LED (200) in der zweiten Richtung (y) nähern,

- eine dritte Übergangszone (3000), die sich überwiegend in der Ebene (xy) erstreckt und mindestens teilweise an die dritte LED (300) und die erste LED (100) angrenzt, wobei die dritte Übergangszone (3000) eine Vielzahl von dritten Übergangsnanodrähten (3001) umfasst, die dritte Übergangsdurchmesser aufweisen und in $N_{\text{übergang,y,3}}$ Reihen angeordnet sind, die in der ersten Richtung (x) ausgerichtet sind, als dritte sekundäre Übergangsreihen bezeichnet werden und gemäß einer Nummerierung von 1 bis $N_{\text{übergang,y,3}}$ indiziert sind, während sie sich der ersten LED (100) in der zweiten Richtung (y) nähern,

wobei die zweite und die dritte LED (200, 300) durch die zweite Übergangszone (2000) getrennt sind, wobei die dritte und die erste LED (300, 100) durch die dritte Übergangszone (3000) getrennt sind, wobei die zweiten Nanodrähte der zweiten Übergangszone (2000) derart sind, dass:

     i. der Wert der zweiten Übergangsdurchmesser der zweiten Übergangsnanodrähte (2001) der zweiten Übergangsreihe Nr. 1 in einem Verhältnis von weniger als 5 % des dritten Zieldurchmessers $\varphi_{30}$ variiert, und
     ii. der Wert des zweiten Übergangsdurchmessers jedes zweiten Übergangsnanodrahts (2001) jeder zweiten sekundären Übergangsreihe Nr. i, wobei i zwischen 2 und $N_{\text{übergang,y,2}}$ liegt, in einem Verhältnis zwischen 3 % und 13 % des Werts des zweiten Übergangsdurchmessers des zweiten Übergangsnanodrahts (2001) der zweiten sekundären Übergangsreihe Nr. i-1, der ihm am nächsten liegt, variiert, und
     iii. der Wert der zweiten Übergangsdurchmesser der zweiten Übergangsnanodrähte (2001) der zweiten Übergangsreihe Nr. $N_{\text{übergang,y,2}}$ in einem Verhältnis von weniger als 5 % des zweiten Zieldurchmessers $\varphi_{20}$ variiert, und/oder

     i. die zweite sekundäre Reihe Nr. 1 und die zweite sekundäre Übergangsreihe Nr. $N_{\text{übergang,y,2}}$ in der zweiten Richtung (y) durch einen dritten Grenzflächenabstand $d_{\text{interface,3}}$ getrennt sind, wobei der dritte Grenzflächenabstand $d_{\text{interface,3}}$ und der Abstand in der zweiten Richtung (y) zwischen der zweiten sekundären Übergangsreihe Nr. $N_{\text{übergang,y,2}}$ und der zweiten sekundären Übergangsreihe Nr. $N_{\text{übergang,y,2}}$-1 in einem Verhältnis zwischen 2 % und 4 % des Abstands in der zweiten Richtung (y) zwischen der zweiten sekundären Übergangsreihe Nr. $N_{\text{übergang,y,2}}$ und der zweiten sekundären Übergangsreihe Nr. $N_{\text{übergang,y,2}}$-1 bzw. des dritten Grenzflächenabstands $d_{\text{interface,3}}$ variieren,

ii. der Abstand in der zweiten Richtung (y) zwischen jeder zweiten sekundären Übergangsreihe Nr. i und der zweiten sekundären Übergangsreihe Nr. i+1 in einem Verhältnis zwischen 2 % und 4 % des Abstands in der zweiten Richtung (y) zwischen der zweiten sekundären Übergangsreihe Nr. i-1 und der zweiten sekundären Übergangsreihe Nr. i variiert, wobei i zwischen 2 und $N_{\text{übergang,y,2}}$-1 liegt, und

iii. die dritte sekundäre Reihe Nr. $N_{\text{LED,y,3}}$ und die zweite sekundäre Übergangsreihe Nr. 1 in der zweiten Richtung (y) durch einen vierten Grenzflächenabstand $d_{\text{interface,4}}$ getrennt sind, wobei der vierte Grenzflächenabstand $d_{\text{interface,4}}$ und der Abstand in der zweiten Richtung (y) zwischen der zweiten sekundären Übergangsreihe Nr. 2 und der zweiten sekundären Übergangsreihe Nr. 1 in einem Verhältnis zwischen 2 % und 4 % des Abstands in der zweiten Richtung (y) zwischen der dritten sekundären Reihe Nr. $N_{\text{LED,y,3}}$ und der dritten sekundären Reihe Nr. $N_{\text{LED,y,3}}$-1 bzw. des vierten Grenzflächenabstands $d_{\text{interface,4}}$ variieren,

und wobei die dritten Nanodrähte der dritten Übergangszone (3000) derart sind, dass:

     i. der Wert der dritten Übergangsdurchmesser der dritten Übergangsnanodrähte (3001) der dritten Übergangsreihe Nr. 1 in einem Verhältnis von weniger als 5 % des dritten Zieldurchmessers $\varphi_{30}$ variiert, und

ii. der Wert des dritten Übergangsdurchmessers jedes dritten Übergangsnanodrahts (3001) jeder dritten sekundären Übergangsreihe Nr. i, wobei i zwischen 2 und $N_{übergang,y,3}$ liegt, in einem Verhältnis zwischen 3 % und 13 % des Werts des dritten Übergangsdurchmessers des dritten Übergangsnanodrahts (3001) der dritten sekundären Übergangsreihe Nr. i-1, der ihm am nächsten liegt, variiert, und

iii. der Wert der dritten Übergangsdurchmesser der dritten Übergangsnanodrähte (3001) der dritten Übergangsreihe Nr. $N_{übergang,y,3}$ in einem Verhältnis von weniger als 5 % des ersten Zieldurchmessers $\varphi_{10}$ variiert, und/oder

i. die erste sekundäre Reihe Nr. 1 und die dritte sekundäre Übergangsreihe Nr. $N_{übergang,y,3}$ in der zweiten Richtung (y) durch einen sechsten Grenzflächenabstand $d_{interface,6}$ getrennt sind, wobei der sechste Grenzflächenabstand $d_{interface,6}$ und der Abstand in der zweiten Richtung (y) zwischen der dritten sekundären Übergangsreihe Nr. $N_{übergang,y,3}$ und der dritten sekundären Übergangsreihe Nr. $N_{übergang,y,3}$-1 in einem Verhältnis zwischen 2 % und 4 % des Abstands in der zweiten Richtung (y) zwischen der dritten sekundären Übergangsreihe Nr. $N_{übergang,y,3}$ und der dritten sekundären Übergangsreihe Nr. $N_{übergang,y,3}$-1 bzw. des sechsten Grenzflächenabstands $d_{interface,3}$ variieren,

ii. der Abstand in der zweiten Richtung (y) zwischen jeder dritten sekundären Übergangsreihe Nr. i und der dritten sekundären Übergangsreihe Nr. i+1 in einem Verhältnis zwischen 2 % und 4 % des Abstands in der zweiten Richtung (y) zwischen der dritten sekundären Übergangsreihe Nr. i-1 und der dritten sekundären Übergangsreihe Nr. i variiert, wobei i zwischen 2 und $N_{übergang,y,3}$-1 liegt, und

iii. die dritte sekundäre Reihe Nr. $N_{LED,y,3}$ und die dritte sekundäre Übergangsreihe Nr. 1 in der zweiten Richtung (y) durch einen fünften Grenzflächenabstand $d_{interface,5}$ getrennt sind, wobei der fünfte Grenzflächenabstand $d_{interface,5}$ und der Abstand in der zweiten Richtung (y) zwischen der dritten sekundären Übergangsreihe Nr. 2 und der dritten sekundären Übergangsreihe Nr. 1 in einem Verhältnis zwischen 2 % und 4 % des Abstands in der zweiten Richtung (y) zwischen der dritten sekundären Reihe Nr. $N_{LED,y,3}$ und der dritten sekundären Reihe Nr. $N_{LED,y,3}$-1 bzw. des vierten Grenzflächenabstands $d_{interface,4}$ variieren.

**Claims**

1. An optoelectronic device (1) comprising at least:

   - a first LED (100) extending mainly in a plane (xy) defined by a first direction (x) and a second direction (y), said first LED (100) comprising a plurality of first nanowires (101) having first diameters having a value substantially equal to a first target diameter $\varphi_{10}$ and organised into $N_{LED,x,1}$ rows oriented in the second direction (y), called first rows, said first rows being separated by first distances taken in the first direction (x) having a value substantially equal to a first target distance $p_{10,x}$, said first LED (100) being configured to emit a first light beam having mainly a first wavelength $\lambda_1$, and
   - a first transition area (1000) extending mainly in the plane (xy) and at least partly bordering said first LED (100), said first transition area (1000) comprising a plurality of first transition nanowires (1001) having first transition diameters and organised into $N_{trans,x,1}$ rows oriented in the second direction (y), called first transition rows and indexed according to a numbering from 1 to $N_{trans,x,1}$ moving away from the first LED (100) in the first direction (x), the first rows being indexed according to a numbering from 1 to $N_{LED,x,1}$ in the first direction (x) approaching the first transition area (1000),

   the device being **characterised in that** the first transition area (1000) comprises a first transition sub-area (1100) formed by the $N_{sub-trans,1}$ first transition rows, with $2 \leq N_{sub-trans,1} \leq N_{trans,x,1}$, bordering the first LED (100), first transition sub-area (1100) wherein:

   - the first transition nanowires (1001) are such that:

     i. the value of the first transition diameters of the first transition nanowires (1001) of the first transition row n°1 varies in a proportion less than 5% of the first target diameter $\varphi_{10}$, and

ii. the value of the first transition diameter of the first transition nanowire (1001) of any first transition row n°i, i being comprised between 2 and $N_{sub-trans,1}$, varies in a proportion comprised between 3% and 13% of the value of the first transition diameter of the first transition nanowire (1001) of the first transition row n°i-1 being closest thereto, and/or

- the first transition nanowires (1001) are such that:

i. the first row n°$N_{LED,x,1}$ and the first transition row n°1 being separated in the first direction x by a first interface distance $d_{interface,1}$, the first interface distance $d_{interface,1}$ and the distance in the first direction (x) between the first transition row n°1 and the first transition row n°2 vary in a proportion comprised between 2% and 4% of the distance in the first direction (x) between the first row n°$N_{LED,x,1}$-1 and the first row n°$N_{LED,x,1}$ and the first interface distance $d_{interface,1}$ respectively, and

ii. the distance in the first direction (x) between any first transition row n°i and the first transition row n°i+1 varies in a proportion comprised between 2% and 4% of the distance in the first direction (x) between the first transition row n°i-1 and the first transition row n°i, i being comprised between 2 and $N_{sub-trans,1}$-1.

2. The optoelectronic device (1) according to the preceding claim wherein the first transition diameters of the first transition nanowires (1001) of the same first transition row are equal.

3. The optoelectronic device (1) according to any one of the preceding claims wherein:

- the value of the first transition diameters of the first transition nanowires (1001) of the first transition rows has a strictly increasing or strictly decreasing evolution over at least three successive first transition rows moving away from the first LED (100), and/or
- the distance between two successive first transition rows moving away from the first LED (100) has a strictly increasing or strictly decreasing evolution over at least three successive first transition rows moving away from the first LED (100).

4. The optoelectronic device (1) according to the preceding claim wherein:

- the value of the first transition diameters of the first transition nanowires (1001) of the first transition rows has a linear evolution over at least three successive first transition rows moving away from the first LED (100), and/or
- the distance between two successive first transition rows moving away from the first LED (100) has a linear evolution over at least three successive first transition rows moving away from the first LED (100).

5. The optoelectronic device (1) according to the preceding claim wherein the first nanowires (101) and the first transition nanowires (1001) are further organised into rows in the first direction (x).

6. The optoelectronic device (1) according to any one of the preceding claims wherein the first transition sub-area (1100) extends over at least three rows, preferably at least five rows, of first transition nanowires (1001).

7. The optoelectronic device (1) according to any one of the preceding claims wherein the first transition sub-area (1100) has a surface $S_{1000}$ and the first LED (100) has a surface $S_{100}$ such that $S_{100}/5 < S_{1000} < S_{100}/2$.

8. The optoelectronic device (1) according to any one of the preceding claims wherein the first nanowires (101) on the one hand and the first transition nanowires (1001) on the other hand are supplied by separate electrical contacts.

9. The optoelectronic device (1) according to any one of the preceding claims further comprising:

- a second LED (200) extending mainly in the plane (xy), said second LED (200) comprising a plurality of second nanowires (201) having second diameters having a value substantially equal to a second target diameter $\varphi_{20}$ and organised into $N_{LED,x,2}$ rows oriented in the second direction (y), called second rows, and indexed according to a numbering from 1 to $N_{LED,x,2}$ moving away from the first transition area (1000) in the first direction (x), said second rows being separated by first distances taken in the first direction (x) having a value substantially equal to a second target distance $p_{20,x}$, said second LED (200) being configured to emit a second light beam having mainly a second wavelength $\lambda_2$,

said first and second LEDs (100, 200) being separated at least by the first transition area (1000).

10. The optoelectronic device (1) according to the preceding claim wherein $N_{Sub-trans,1} = N_{trans,x,1}$ and wherein:

- the value of the first transition diameters of the first transition nanowires (1001) of the first transition row n°$N_{sub-trans,1}$ varies in a proportion of less than 5% of the second target diameter $\varphi_{20}$, and/or
- the second row n°1 and the first transition row n°$N_{sub-trans,1}$ being separated in the first direction (x) by a second interface distance $d_{interface,2}$,
- the distance in the first direction (x) between the first transition row n°$N_{sub-trans,1}$ and the first transition row n°$N_{sub-trans,1}$-1 varies in a proportion comprised between 2% and 4% of the second interface distance $d_{interface,2}$.

11. The optoelectronic device (1) according to claim 9 wherein the first transition area (1000) comprises a second transition sub-area (1200) formed by the first transition rows n°$N_{sub-trans,2}$ to $N_{trans,x,1}$, with $N_{sub-trans,1} \leq N_{sub-trans,2} \leq N_{trans,x,1}$, second transition sub-area (1200) wherein:

- the first transition nanowires (1001) are such that:

i. the value of the first transition diameters of the first transition nanowires (1001) of the first transition row n°$N_{trans,x,1}$ varies in a proportion less than 5% of the second target diameter $\varphi_{20}$, and

ii. the value of the first transition diameters of the first transition nanowires (1001) of any first transition row n°i, i being comprised between $N_{sub-trans,2}$ and $N_{trans,x,1}$-1 varies in a proportion comprised between 3% and 13% of the value of the first transition diameters of the first transition nanowires (1001) of the first transition row n°i+1, and/or

- the first transition nanowires (1001) are such that:

i. the second row n°1 and the first transition row n°$N_{trans,x,1}$ being separated in the first direction x by a second interface distance $d_{interface,2}$, the distance in the first direction (x) between the first transition row n°$N_{trans,x,1}$ and the first transition row n°$N_{trans,x,1}$-1 and the second interface distance $d_{interface,2}$ vary in a proportion comprised between 2% and 4% of the second interface distance $d_{interface,2}$ and the distance in the first direction (x) between the second row n°1 and the second row n°2 respectively,

ii. the distance in the first direction (x) between any first transition row n°i and the first transition row n°i-1 varies in a proportion comprised between 2% and 4% of the distance in the first direction (x) between the first transition row n°i and the first transition row n°i+1, i being comprised between $N_{trans,x,1}$-1 and $N_{sub-trans,2}$+1.

12. The optoelectronic device (1) according to the preceding claim wherein:

- the value of the first transition diameters of the first transition nanowires (1001) of the first transition rows has a strictly increasing or strictly decreasing evolution over at least three successive first transition rows moving away from the second LED (200), and/or
- the distance between two successive first transition rows moving away from the first LED (100) has a strictly increasing or strictly decreasing evolution over at least three successive first transition rows moving away from the second LED (200).

13. The optoelectronic device (1) according to the preceding claim wherein:

- the value of the first transition diameters of the first transition nanowires (1001) of the first transition rows has a linear evolution over at least three successive first transition rows moving away from the second LED (200), and/or
- the distance between two successive first transition rows moving away from the first LED (100) has a linear evolution over at least three successive first transition rows moving away from the second LED (200).

14. The optoelectronic device (1) according to any one of the preceding claims wherein at least part of the first transition nanowires (1001) comprise an active region (1002) configured to emit a first transition light beam which mainly has a first transition wavelength $\lambda_{trans,1}$, with $\lambda_{trans,1} \neq \lambda_1$ and $\lambda_{trans,1} \neq \lambda_2$.

15. The optoelectronic device (1) according to any one of claims 9 to 14 wherein:

- the first nanowires (101) are organised into $N_{LEE,y,1}$ rows oriented in the first direction (x), called first secondary rows, indexed according to a numbering from 1 to $N_{LED,y,1}$ and separated by first secondary distances taken in the second direction (y) having a value substantially equal to a first target secondary distance $p_{10,y}$, and
- the second nanowires (201) are organised into $N_{LEE,y,2}$ rows oriented in the first direction (x), called second secondary rows and indexed according to a numbering from 1 to $N_{LED,y,2}$ and separated by second secondary distances taken in the second direction (y) having a value substantially equal to a second target secondary distance P20,y.

16. The optoelectronic device (1) according to the preceding claim further comprising:

- a third LED (300) extending mainly in the plane (xy), said third LED (300) comprising a plurality of third nanowires (301) having third diameters having a value substantially equal to a third target diameter $\varphi_{30}$ and organised into $N_{LED,x,3}$ rows oriented in the second direction (y), called third rows and into $N_{LEE,y,3}$ rows oriented in the first direction (x), called third secondary rows, said third LED (300) being configured to emit a third light beam having mainly a third wavelength $\lambda_3$,

- a second transition area (2000) extending mainly in the plane (xy) and at least partly bordering said second LED (200) and said third LED (300), said second transition area (2000) comprising a plurality of second transition nanowires (2001) having second transition diameters and organised into $N_{trans,y,2}$ rows oriented in the first direction (x), called second secondary transition rows and indexed according to a numbering from 1 to $N_{trans,y,2}$ approaching the second LED (200) in the second direction (y),

- a third transition area (3000) extending mainly in the plane (xy) and at least partly bordering said third LED (300) and said first LED (100), said third transition area (3000) comprising a plurality of third transition nanowires (3001) having third transition diameters and organised into $N_{trans,y,3}$ rows oriented in the first direction (x), called third secondary transition rows and indexed according to a numbering from 1 to $N_{trans,y,3}$ approaching the first LED (100) in the second direction (y), said second and third LEDs (200, 300) being separated by the second transition area (2000), said third and first LEDs (300, 100) being separated by the third transition area (3000), wherein the second nanowires of the second transition area (2000) are such that:

i. the value of the second transition diameters of the second transition nanowires (2001) of the second transition row n°1 varies in a proportion less than 5% of the third target diameter $\varphi_{30}$, and
ii. the value of the second transition diameter of each second transition nanowire (2001) of any second secondary transition row n°i, i being comprised between 2 and

$N_{trans,y,2}$, varies in a proportion comprised between 3% and 13% of the value of the second transition diameter of the second transition nanowire (2001) of the second secondary transition row n°i-1 closest thereto, and
iii. the value of the second transition diameters of the second transition nanowires (2001) of the second transition row n°$N_{trans,y,2}$ varies in a proportion less than 5% of the second target diameter $\varphi_{20}$,
and/or

i. the second secondary row n°1 and the second secondary transition row n°$N_{trans,y,2}$ being separated in the second direction (y) by a third interface distance $d_{interface,3}$, the third interface distance $d_{interface,3}$ and the distance in the second direction (y) between the second secondary transition row n°$N_{trans,y,2}$ and the second secondary transition row n°$N_{trans,y,2}$-1 vary in a proportion comprised between 2% and 4% of the distance in the second direction (y) between the second secondary transition row n°$N_{trans,y,2}$ and the second secondary transition row n°$N_{trans,y,2}$-1 and the third interface distance $d_{interface,3}$ respectively,
ii. the distance in the second direction (y) between any second secondary transition row n°i and the second secondary transition row n° i + 1 varies in a proportion comprised between 2% and 4% of the distance in the second direction (y) between the second secondary transition row n°i-1 and the second secondary transition row n°i, i being comprised between 2 and $N_{trans,y,2}$-1, and
iii. the third secondary row n°$N_{LED,y,3}$ and the second secondary transition row n°1 being separated in the second direction (y) by a fourth interface distance $d_{interface,4}$, the fourth interface distance $d_{interface,4}$ and the distance in the second direction (y) between the second secondary transition row n°2 and the second secondary transition row n°1 vary in a proportion comprised between 2% and 4% of the distance in the second direction (y) between the third secondary row n°$N_{LED,y,3}$ and the third secondary row n°$N_{LED,y,3}$-1 and the fourth interface distance $d_{interface,4}$ respectively,

and wherein the third nanowires of the third transition area (3000) are such that:

i. the value of the third transition diameters of the third transition nanowires (3001) of the third transition row n°1 varies in a proportion less than 5% of the third target diameter $\varphi_{30}$, and

ii. the value of the third transition diameter of each third transition nanowire (3001) of any third secondary transition row n°i, i being comprised between 2 and $N_{trans,y,3}$, varies in a proportion comprised between 3% and 13% of the value of the third transition diameter of the third transition nanowire (3001) of the third secondary transition row n°i-1 closest thereto, and

iii. the value of the third transition diameters of the third transition nanowires (3001) of the third transition row n°$N_{trans,y,3}$ varies in a proportion less than 5% of the first target diameter $\varphi_{10}$, and/or

i. the first secondary row n°1 and the third secondary transition row n°$N_{trans,y,3}$ being separated in the second direction (y) by a sixth interface distance $d_{interface,6}$, the sixth interface distance $d_{interface,6}$ and the distance in the second direction (y) between the third secondary transition row n°$N_{trans,y,3}$ and the third secondary transition row n°$N_{trans,y,3}$-1 vary in a proportion comprised between 2% and 4% of the distance in the second direction (y) between the third secondary transition row n°$N_{trans,y,3}$ and the third secondary transition row n°$N_{trans,y,3}$-1 and the sixth interface distance $d_{interface,3}$ respectively,

ii. the distance in the second direction (y) between any third secondary transition row n°i and the third secondary transition row n° i + 1 varies in a proportion comprised between 2% and 4% of the distance in the second direction (y) between the third secondary transition row n°i-1 and the third secondary transition row n°i, i being comprised between 2 and $N_{trans,y,3}$-1, and

iii. the third secondary row n°$N_{LED,y,3}$ and the third secondary transition row n°1 being separated in the second direction (y) by a fifth interface distance $d_{interface,5}$, the fifth interface distance $d_{interface,5}$ and the distance in the second direction (y) between the third secondary transition row n°2 and the third secondary transition row n°1 vary in a proportion comprised between 2% and 4% of the distance in the second direction (y) between the third secondary row n°$N_{LED,y,3}$ and the third secondary row n°$N_{LED,y/3}$-1 and the fourth interface distance $d_{interface,4}$ respectively.

FIG. 1

FIG. 2

FIG. 3

FIG. 4a

FIG. 4b

FIG. 5

FIG. 6a

FIG. 6b

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014154880 A1
- WO 2022069431 A1

- WO 2022002896 A1